# EUROPEAN PATENT SPECIFICATION

(11) **EP 3 043 397 B1**
(45) Date of publication and mention of the grant of the patent: **28.03.2018**
(21) Application number: 14842363.5
(22) Date of filing: 05.09.2014
(51) Int. Cl.: H01L 51/54, H01L 51/50, C08G 79/14, C09K 11/06

(54) **METHOD FOR MANUFACTURING A THIN FILM FOR ORGANIC ELECTROLUMINESCENCE (EL) DEVICE**
VERFAHREN ZUR HERSTELLUNG EINER DÜNNSCHICHT FÜR EINE ORGANISCHE ELEKTROLUMINESZENZ (EL)-VORRICHTUNG
PROCÉDÉ DE FABRICATION D'UN FILM MINCE POUR UN DISPOSITIF À ÉLECTROLUMINESCENCE ORGANIQUE (EL)

(30) Priority: 05.09.2013 JP 2013183620
(43) Date of publication of application: 13.07.2016
(73) Proprietor: National University Corporation Hokkaido University, Sapporo-shi, Hokkaido 060-0808 (JP); Stanley Electric Co., Ltd., Meguro-ku Tokyo 153-8636 (JP)
(72) Inventor: HASEGAWA Yasuchika, Sapporo-shi Hokkaido 060-0808 (JP); SUGAWARA Takeshi, Sapporo-shi Hokkaido 060-0808 (JP); AKAGI Tsutomu, Tokyo 153-8636 (JP); SATO Masanori, Tokyo 153-8636 (JP); UENO Kazuhiko, Tokyo 153-8636 (JP)
(74) Representative: Michalski Hüttermann & Partner Patentanwälte mbB
(86) International application number: PCT/JP2014/073462
(87) International publication number: WO 2015/034041

(56) References cited:
- JP-A- 2001 338 757
- JP-A- 2002 231 452
- JP-A- 2005 056 693
- JP-A- 2005 120 209
- JP-A- 2010 095 514
- KOHEI MIYATA ET AL.: 'Thermostable Organo- phosphor: Low-Vibrational Coordination Polymers That Exhibit Different Intermolecular Interactions' CHEMPLUSCHEM vol. 77, no. 4, 14 February 2012, pages 277 - 280, XP055309056

## Description

### Technical Field

The present invention relates to a thin film for an organic EL device and to a method for manufacturing the same. The present invention also relates to an organic EL device employing this thin film.

### Background Art

Fluorescent materials and phosphorescent materials are employed as light-emitting materials in organic ELs. They include both low molecular weight and high molecular weight materials. While thinner films are possible using vapor deposition techniques in the case of low molecular weight materials, thinner films can also be achieved with high molecular weight materials by printing them in the form of inks.

Since rare earth complexes emit intense light of high chromatic purity by ligand excitation, they are interesting compounds as materials in new light-emitting devices. Recently, the present inventors successfully developed a rare earth complex polymer affording both a high luminescence quantum yield and thermal durability (Patent Reference 1, Nonpatent Reference 1).

Patent Reference 1: WO2012/150712

Nonpatent Reference 1: ChemPlusChem 2012,77,277-280

Rare earth metal-ligand complexes and processes for achieving such complexes are for instance disclosed in JP 2010 095514 A and in KOHEI MIYATA ET AL., "Thermostable Organo- phosphor: Low-Vibrational Coordination Polymers That Exhibit Different Intermolecular Interactions", CHEMPLUSCHEM, (20120214), vol. 77, no. 4, pages 277 - 280, XP055309056.

### Summary of the Invention

### Problem to be solved by the Invention

New display devices can be expected when organic thin-film electrodes are developed from the complex polymer described in Patent Reference 1 and Nonpatent Reference 1. However, this rare earth complex polymer has extremely low solubility in organic solvents, and presents the drawback of not permitting the formation of thin films by conventional physical and chemical fabrication methods.

Accordingly, one object of the present invention is to provide a new method for manufacturing thin films of rare earth complex polymers with low solubility in organic solvents. A further object of the present invention is to provide a new organic EL device having a luminescent layer in the form of a thin film of a rare earth complex polymer obtained by this new method.

The present inventors employed a ferrocenyl surfactant to separately micellize a rare earth complex constituting a polymer and a crosslinking material capable of linking rare earth complexes. A mixture of these micelles was then formed. The mixed micelles obtained were then electrolyzed, and the ferrocenyl surfactant was electrochemically oxidized to break down the micelles, resulting in the successful formation of a thin film of a rare earth complex polymer on the electrode.

The thin film of rare earth complex polymer obtained by this method was discovered to have a high luminescence quantum yield similar to that of a bulk rare earth complex polymer, and to permit the construction of organic EL devices. The present invention was devised on that basis.

### Means of Solving the Problem

[1] A method for manufacturing a thin film of a rare earth complex polymer comprising the steps of:
   (1) mixing a solution A containing micelles containing a rare earth complex and a ferrocenyl surfactant and a solution B containing micelles containing polydentate ligands and a ferrocenyl surfactant to form a solution containing a mixture of micelles;
   (2) electrolyzing the solution containing a mixture of micelles as an electrolyte, forming a thin film of a rare earth complex polymer containing the rare earth complex and the polydentate ligands on the anode surface; wherein:
      - the rare earth complex comprises a rare earth ion and a ligand denoted by formula (1) below coordinated with the rare earth ion: 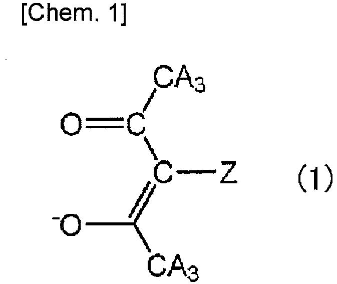 (in the formula, A denotes a hydrogen atom or a halogen atom and Z denotes a hydrogen atom or a deuterium atom);
      - the polydentate ligand is a compound having two or more of at least one type coordinating functional groups to rare earth ion; and
      - the rare earth compound polymer comprises a crosslinked structure of the polydentate ligand and rare earth complex.
[2] The manufacturing method according to claim 1, wherein the mixture is left standing for 0 to 48 hours after mixing solutions A and B containing micelles in forming the solution containing a mixture of micelles in step (1), and then is subjected to electrolysis in step (2).
[3] The manufacturing method according to claim 1 or 2, wherein solutions A and B containing micelles are formed so that the average diameter of the micelles is less than or equal to 500 nm.
[4] The manufacturing method according to any one of claims 1 to 3, wherein in step (2), the average diameter of the mixed micelles subjected to electrolysis is greater than the average diameter of solutions A and B containing micelles prior to mixing.
[5] The manufacturing method according to any one of claims 1 to 4, wherein the ferrocenyl surfactant is ferrocenyl polyethylene glycol.
[6] The manufacturing method according to any one of claims 1 to 5, wherein the thickness of the thin film of rare earth complex polymer falls within a range of 1 to 1,000 nm.
[7] The manufacturing method according to any one of claims 1 to 6, wherein the polydentate ligand is a compound comprising two or more of at least one coordinating functional group selected from the group consisting of phosphine oxide groups, pyridyl groups, carboxylic acid groups, and ester groups.
[8] The manufacturing method according to any one of claims 1 to 6, wherein the polydentate ligand is the phosphine oxide bidentate ligand denoted by formula (2) below: 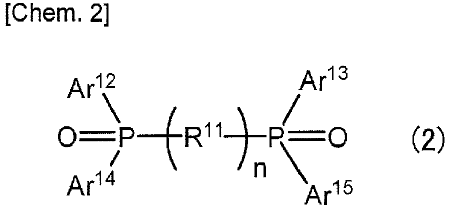 (in the formula, R¹¹ denotes a divalent organic group; each of Ar¹², Ar¹³, Ar¹⁴, and Ar¹⁵ independently denotes an optionally substituted monovalent aromatic group, it being possible for Ar¹² and Ar¹³, and Ar¹⁴ and Ar¹⁵, to be directly bonded together or bonded through connecting groups; and n denotes an integer of 1 to 20).
[9] The manufacturing method according to claim 8, wherein R¹¹ is the group denoted by formula (3a) below, the group denoted by formula (3b) below, the group denoted by formula (3c) below, or the group denoted by formula (3d) below: 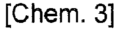 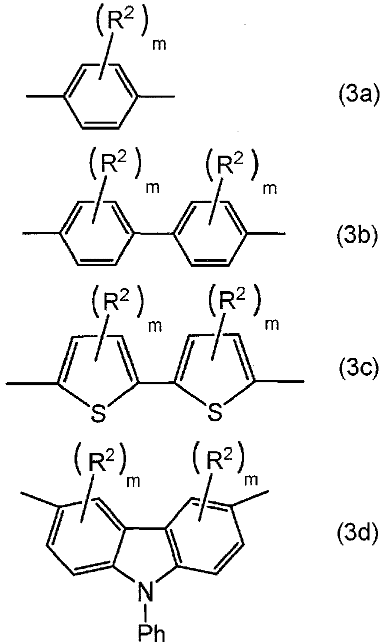 (in the formulas, R² denotes a monovalent organic group, m denotes an integer of from 0 to the number of sites permitting substitution on the ring to which R² is bonded; and Ph denotes a phenyl group; such that when m is greater than or equal to 2, the multiple instances of R² can be identical or different).
[10] The manufacturing method according to claim 9, wherein a single rare earth ion forms a coordination structure with a coordination number of greater than or equal to 8, in which a plurality of phosphine oxide polydentate ligands are coordinated at a single site each with the rare earth ion, and a plurality of the ligand denoted by formula (1) are coordinated at two sites each with the rare earth ion.

### Brief Description of the Drawings

[Figure 1] Figure 1 shows the results of measurement of the particle size distribution of micelles containing Eu(hfa)₃(H₂O)₂ formed in the Examples.
[Figure 2] Figure 2 shows the results of measurement of the particle size distribution of micelles containing dpbp formed in the Examples.

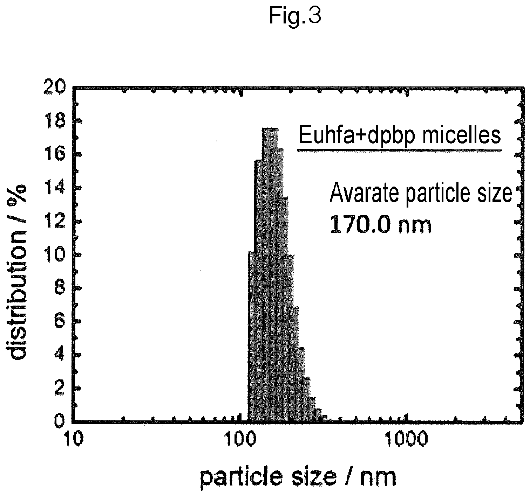

[Figure 3] Figure 3 shows the results of measurement of the particle size of mixed micelles formed in the Examples.
[Figure 4] Figure 4 shows the light-emission spectrum of an ITO electrode following electrolysis of a mixed micelle solution obtained in the Examples.
[Figure 5] Figure 5 is a picture showing the light-emission state of an ITO electrode following electrolysis of a micelle solution containing Eu(hfa)₃(H₂O)₂ and an ITO electrode following electrolysis of a mixed micelle solution obtained in the Examples.
[Figure 6] Figure 6 shows the dependence of the diameter of the micelle particles obtained in Reference Example 2-1 on the quantity of Eu(hfa)₃(H₂O)₂.
[Figure 7] Figure 7 shows the dependence of the diameter of the micelle particles obtained in Reference Example 2-1 on the FePEG concentration.
[Figure 8] Figure 8 shows the dependence of the diameter of the micelle particles obtained in Reference Example 2-1 on the FePEG concentration.

### Modes of Carrying Out the Invention

### [The method for manufacturing a thin film of rare earth complex polymer]

The method for manufacturing a thin film of rare earth complex polymer of the present invention comprises steps (1) and (2) below.
(1) mixing a solution A containing micelles containing a rare earth complex and a ferrocenyl surfactant and a solution B containing micelles containing polydentate ligands and a ferrocenyl surfactant to form a solution containing a mixture of micelles;
(2) electrolyzing the solution containing a mixture of micelles as an electrolyte, forming a thin film of a rare earth complex polymer containing the rare earth complex and the polydentate ligands on the anode surface.

### <Step (1)>

### <Micelle-containing solution A>

Micelle-containing solution A contains a rare earth complex and a ferrocenyl surfactant.

The rare earth complex contains a rare earth element ion (also referred to as a rare earth ion hereinafter) and the ligand denoted by formula (1) below coordinated with the rare earth ion.

By way of example, the rare earth element can be one or more elements selected from the group consisting of Sc, Y, La, Ce, Pr, Nd, Pm, Sm, Eu, Gd, Tb, Dy, Ho, Er, Tm, Yb, and Lu. Rare earth element ions are ions with a specific valence for each element. Examples are cations of +2 valence or +3 valence. From the perspective of obtaining a light-emitting material, rare earth ions in the form of, for example, Eu³⁺, Tb³⁺, Gd³⁺, Tm³⁺, or Er³⁺ are desirable. For example, in the case where the rare earth ion is Eu³⁺, red luminescence is exhibited, and in the case where the rare earth ion is Tb³⁺, green luminescence is exhibited. The rare earth complex that is employed in the present invention includes complexes in which a single type of rare earth ion is present, and complexes in which two or more types of rare earth ions are present. Among the rare earth ions, Ce, Pr, Nd, Pm, Sm, Eu, Gd, Tb, Dy, Ho, Er, Tm, Yb, and Lu have 4f electrons, so coordination numbers of 8 to 10 can be achieved. The coordination number is determined by the type of rare earth ion and the valence number. Sc, Y, and La ions do not have 4f electrons, so only the d and s electrons contribute to coordination bonds. As a result, they yield 2 to 4 coordination.

The compounds denoted by general formula (1) are diketo compounds which are bidentate compounds. In general formula (1), each instance of A independently denotes a hydrogen atom, an alkyl group with 1 to 6 carbon atoms, or a halongen atom. Z denotes a hydrogen atom or a deuterium atom. Examples of alkyl groups with 1 to 6 carbon atoms are methyl groups, ethyl groups, propyl groups (*n*- and *iso*-), butyl groups *(n-* and *tert*-), pentyl groups, and hexyl groups.

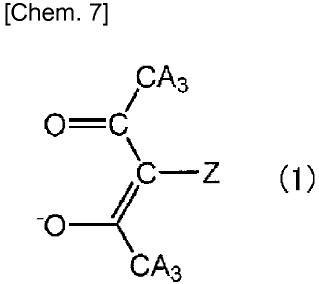

More specific examples of the diketo compound denoted by general formula (2) are one or more compounds selected from the group consisting of acetyl acetone (acac), 2,2,6,6-tetramethylheptane-3,5-dione (TMHD), 1,1,1-trifluoroacetylacetone (TFA), and 1,1,1,5,5,5-hexafluoroacetylacetone (HFA). These are known compounds.

The rare earth complex can be prepared from the compound containing a rare earth ion and the compound containing the ligand shown in formula (1). This rare earth complex is known and can be prepared by known methods. An example is that described in Patent Reference 1.

The fact that ferrocenyl surfactants can be used in micelle electrolysis methods to form thin films of inorganic powders is known (examples are: Japanese Unexamined Patent Publication (KOKAI) Heisei Nos. 10-310898 and 11-241198, and Japanese Unexamined Patent Publication (KOKAI) No. 2006-161149). Any ferrocenyl surfactant having the ability to form micelles, such that the ability to form micelles is lost when the iron ion contained in the ferrocenyl group is oxidized on an electrode upon electrolysis, breaking down the ferrocene structure, can be employed without limitation. An example of a ferrocenyl surfactant that is employed in micelle electrolysis methods is ferrocenyl polyethylene glycol. Ferrocenyl polyethylene glycol can also be used in the present invention. The surfactant capability of ferrocenyl polyethylene glycol changes based on the number of repeating units of polyethylene glycol. The number of repeating units of polyethylene glycol can be suitably selected based on the micelle-forming ability that is required of the ferrocenyl polyethylene glycol.

Micelle-containing solution A can contain, for example, a solvent (continuous phase) in the form of water or an aqueous solution, and particles comprised of an organic solvent containing a rare earth complex and a ferrocenyl surfactant. The water-based solvent can contain a material capable of becoming an electrolyte in the electrolysis described farther below. Examples of materials that can become electrolytes are inorganic salts. Examples of inorganic salts are halides of alkali metals such as LiBr, LiCl, NaCl, NaBr, KBr, KCI, NaClO₄, and LiClO₄. The organic solvent is desirably one in which the rare earth complex is highly soluble. Examples include dimethyl ether, dimethoxyethane, acetonitrile, dichoromethane, DMSO, and THF.

The contents of the rare earth complex and ferrocenyl surfactant are suitably determined taking into account the forming of micelles containing a rare earth complex and a ferrocenyl surfactant, and achieving a micelle particle diameter suited to the subsequent mixing of micelles and the forming of a thin film by electrolysis. An example of a micelle particle diameter that is suited to the mixing of micelles and the forming of a thin film by electrolysis is an average diameter of less than or equal to 500 nm. The average diameter of the micelles in micelle-containing solution A is desirably 10 to 500 nm, preferably 20 to 400 nm, more preferably 30 to 300 nm, still more preferably 40 to 200 nm, and yet still more preferably, falls within a range of 50 to 150 nm. The diameter of the micelles depends primarily on the quantity of organic solvent and the quantity of ferrocenyl surfactant. These quantities can be adjusted to control the average diameter of the micelles.

By way of example, the concentration of the rare earth complex in micelle-containing solution A falls within a range of 0.01 to 100 mM. It is suitably determined taking into account the achieving of a micelle particle diameter that is suited to the subsequent mixing of micelles and forming a thin film by electrolysis.

The quantity of ferrocenyl surfactant is suitably determined taking into account the quantity of rare earth complex and the quantity of organic solvent. The quantity of organic solvent is suitably determined taking into account the quantity of rare earth complex and the quantity of ferrocenyl surfactant. Adopting the quantity of rare earth complex as a reference, the molar ratio of rare earth complex to ferrocenyl surfactant falls, for example, within a range of 1:0.1 to 10. Adopting the quantity of rare earth complex as a reference, the quantity of organic solvent can be such that the ratio of rare earth complex (mmol) to organic solvent (volume mL) falls within a range of 1:0.1 to 10.

Micelle-containing solution A can be prepared by stirring and mixing the rare earth complex, the ferrocenyl surfactant, and the organic solvent. This operation can be conducted at room temperature (for example, 10 to 30°C). The stirring and mixing conditions are not specifically limited. By way of example, they can be 1 to 180 minutes at 100 to 1,000 rpm.

### <Micelle-containing solution B>

Micelle-containing solution B contains a polydentate ligand and a ferrocenyl surfactant. The ferrocenyl surfactant is identical to that employed in micelle-containing solution A.

Polydentate ligands are a crosslinking material that can link rare earth complexes together. Any material that is capable of linking two or more rare earth complexes can be employed without limitation. From the perspective of linking rare earth complexes, ligands for rare earth ions are suitable. From the perspective of linking two or more rare earth complexes, a polydentate ligand having two or more ligands per molecule is suitable. Examples of ligands for rare earth ions that are present in polydentate ligands are desirably compounds having at least one coordinating functional group selected from the group consisting of phosphine oxide groups, pyridyl groups, carboxylic acid groups, and ester groups. Compounds that comprise two or more, desirably 2 or 3, of these coordinating functional groups are preferred.

### <Phosphine oxide bidentate ligands>

The phosphine oxide bidentate ligand denoted by formula (2) below is an example of a polydentate ligand. 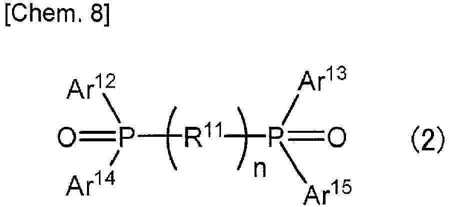 (In the formula (2), R¹¹ denotes a divalent organic group; each of Ar¹², Ar¹³, Ar¹⁴, and Ar¹⁵ independently denotes an optionally substituted monovalent aromatic group, it being possible for Ar¹² and Ar¹³, and Ar¹⁴ and Ar¹⁵, to be directly bonded together, or bonded through connecting groups; and n denotes an integer of 1 to 20).

In formula (2), R¹¹ denotes a divalent organic group. The divalent organic group is not specifically limited. It can be a group in which multiple groups are linked. Examples of R¹¹ are divalent unsaturated groups, divalent aromatic groups, and oxyalkylene groups. Other groups can be bonded to these groups. R¹¹ can be a group that is constituted by bonding a plurality of these divalent groups, or can be a group having the structure of a polymer. Examples of divalent unsaturated groups are alkenylene groups such as vinylene. Examples of aromatic groups are groups comprising an aromatic ring having two bonds with a phosphorus atom. The aromatic ring can have a substituent other than the bonding sites with the phosphorus atom. Examples of aromatic rings are benzene rings, thiophene rings, and pyridine rings. An example of an oxyalkylene group is an oxymethylene group. Examples of groups consisting of a plurality of these divalent groups bonded together are groups in which two or more aromatic rings are bonded, and polyethylene dioxythiophene (PEDOT) having a phosphorous atom bonded to each end.

Of these, a group containing at least one aromatic ring is desirable as R¹¹, and a group containing multiple aromatic rings is preferred. Having R¹¹ contain an aromatic ring, particularly multiple aromatic rings, tends to further increase the heat resistance of the rare earth complex polymer. From the perspective of obtaining even better heat resistance, R¹¹ is desirably in the form of the group denoted by formula (3a), (3b), (3c), or (3d) below; preferably in the form of a group denoted by formula (3b) or (3c) below; and more preferably, in the form of the group denoted by formula (3c) below.

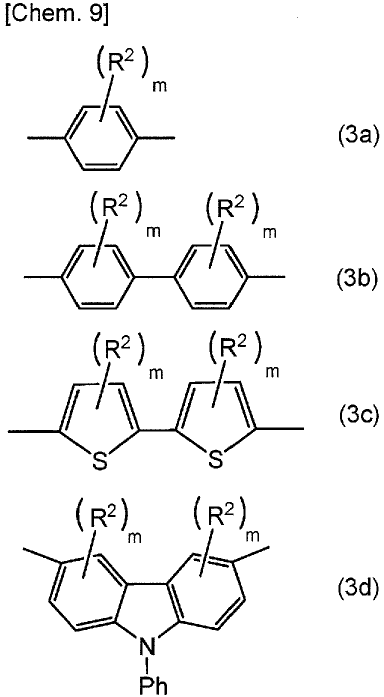

In formulas (3a), (3b), (3c), and (3d), R² denotes a monovalent organic group, and m denotes an integer of from 0 to the number of sites where substitution is possible on the aromatic ring (benzene ring or thiophene ring) to which R² is bonded. Ph denotes a phenyl group. When m is greater than or equal to 2, the multiple instances of R² can be identical or different. Examples of monovalent organic groups as R² are C₁ to C₂₀ hydrocarbon groups, hydroxyl groups, nitro groups, amino groups, sulfonyl groups, cyano groups, silyl groups, phosphonic acid groups, diazo groups, and mercapto groups.

In formula (2), each of Ar¹², Ar¹³, Ar¹⁴, and Ar¹⁵ independently denotes an optionally substituted monovalent aromatic group. The term "monovalent aromatic group" is a group comprised of an aromatic ring having one bond with a phosphorus atom. The aromatic ring can also have a substituent other than the bonding site with the phosphorus atom. Examples of aromatic rings are identical to the aromatic rings capable of forming divalent aromatic groups given for R¹¹. Examples of substituents are groups identical to the monovalent organic groups given for R²; and the group denoted as the phosphine oxide group (-P(=)R³¹R³², where R³¹ and R³² are identical to the examples given for Ar¹², Ar¹³, Ar¹⁴, and Ar¹⁵. When the aromatic groups constituting Ar¹², Ar¹³, Ar¹⁴, and Ar¹⁵ comprise a phosphine oxide group as a substituent, a rare earth ion can be coordinated with that moiety. Ar¹² and Ar¹³, and Ar¹⁴ and Ar¹⁵, can be directly bonded together or can be bonded through a connecting group comprised of an alkylene group, arylene group, carbonyl group, or some other divalent organic group. The group denoted by formula (5) below is an example of each of Ar¹², Ar¹³, Ar¹⁴, and Ar¹⁵ taken independently. 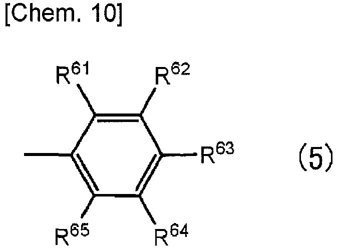 (In formula (5), each of R⁶¹, R⁶², R⁶³, R⁶⁴, and R⁶⁵ independently denotes a hydrogen atom, C₁ to C₂₀ hydrocarbon, hydroxyl group, nitro group, amino group, sulfonyl group, cyano group, silyl group, phosphone group, diazo group, or mercapto group.)

Specific examples of the ligand denoted by formula (1) are: 1,4-bis(diphenylhosphoryl)benzene (dpb), 1,4-bis(diphenylphosphoryl)biphenyl (dpbp), 4,4-bis(diphenylphosphoryl)bithiophene (dpbt), and 3,6-bis(diphenylphosphoryl)-9-phenylcarbazole (dppcz). These compounds can be obtained by the methods described in Patent Reference 1.

An example of a rare earth complex polymer formed using the above bidentate ligand is the structure denoted by formula (6) below. In this example of a rare earth complex polymer, the rare earth ion is an Eu(III) ion. The phosphine oxide polydentate ligand comprises a divalent aromatic group in which the divalent group denoted by R¹¹ above is denoted by Ar¹. It comprises phenyl groups as Ar¹², Ar¹³, Ar¹⁴, and Ar¹⁵. Hexafluoroacetyl acetonate is coordinated with the Eu(III) ion. An 8 conjugation-type conjugation structure is formed by the Eu(III) ion.

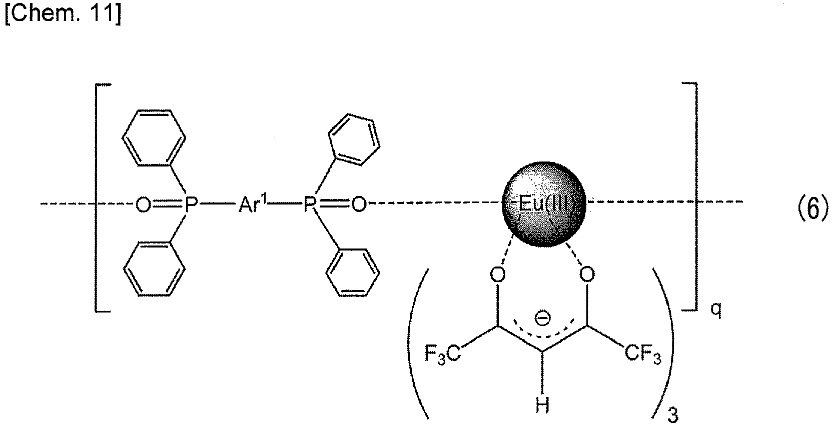

The rare earth ion forms a coordination structure with a coordination number of greater than or equal to 8 by means of multiple phosphine oxide polydentate ligands coordinated at one site each with the rare earth ion, and multiple ligands denoted by formula (1) that are coordinated at two sites each with the rare earth ion.

The compound denoted by general formula (7) below is an example of a phosphine oxide bidentate ligand:

X¹ - L¹ - Ar - L² - X² (7)

In general formula (7), Ar denotes an aromatic heterohydrocarbon group or an aromatic hydrocarbon group. The L¹ and L² that are bonded to the Ar are bent within the molecule about Ar as center. The X¹ and X² that are further bonded to L¹ and L² are modified phosphoryl groups, yielding a coordination bond to the cation. As will be described farther below, in the compound of the present invention, the L¹ and L² that are bonded to the Ar are bonded in such a manner as to bend within the molecule about Ar as center. Modified phosphoryl groups capable of coordination bonding with the cation are also present, so the compound of the present invention and cations can be disposed in alternating fashion to form a complex in the form of a polymer. The complex of the polymer can also be in the form of a complex having a cluster structure. By making the angle of the bend formed by L¹ and L² within the molecule about Ar in the center around 120° (for example, causing it to fall within a range of 90 to 150°), the complex of the polymer can be formed to have a cluster structure containing 2 to 6 compounds. Here, the term "cluster structure" refers to a stabilized molecular structure (complex) in the form of a dimer to hexamer formed by the compound of the present invention through a rare earth element ion(s). A cluster structure will also contain a cyclic structure. Even when forming a cluster structure, the complex can still be dissolved in solvent. The molecular weight thereof can be readily measured based on the MS spectrum.

Examples of aromatic heterohydrocarbon groups are 5 to 14-membered aromatic heterohydrocarbon groups, optionally in the form of fused rings, containing 1 to 3 atoms selected from the group consisting of sulfur atoms, oxygen atoms, and nitrogen atoms.

Examples of single-ring aromatic heterohydrocarbon groups are substituted or unsubstituted azole groups, oxole groups, thiole groups, pyridine groups, pyrylium ion groups, thiopyrylium ion groups, azepine groups, oxepine groups, thiepine groups, imidazole groups, pyrazole groups, oxazole groups, thiazole groups, imidazoline groups, pyrazine groups, and thiazine groups. In compounds in which these groups are present as Ar, L¹ and L² bond at positions 2 and 5 (or positions roughly equivalent to positions 2 and 5), respectively, for azole groups, oxole groups, thiole groups, imidazole groups, oxazole groups, or thiazole groups. They bond at positions 3 and 5 (or positions roughly equivalent to positions 3 and 5), respectively, for pyrazole groups. They bond at positions 2 and 6 (or positions roughly equivalent to positions 2 and 6), respectively, for pyridine groups, pyrylium ion groups, thiopyrylium ion groups, pyrazine groups, and thiazone groups. They bond at positions 2 and 7 (or positions roughly equivalent to positions 2 and 7), respectively, for azepine groups, oxene groups, and thiene groups. By having L¹ and L² bond at these respective positions, as set forth above, it is possible to obtain compounds in which the angle of the bend formed by L¹ and L² within the molecule with Ar in the center is around 120° (for example, falling within a range of 90 to 150°).

Examples of multiple-ring (fused) aromatic heterohydrocarbon groups are substituted and unsubstituted indole groups, isoindole groups, benzoimidazole groups, quinoline groups, isoquinoline groups, quinazoline groups, phthalazine groups, pteridine groups, coumarin groups, chromone groups, 1,4-benzodiazepine, benzofuran groups, acryidine groups, phenoxazine groups, and phenothiazine groups. In compounds comprising these groups, L¹ and L² can be bonded at positions 4 and 6 for indole groups, isoindole groups, benzoimidazole groups, benzofuran groups, isoquinoline groups, and phthalazine groups. They can be bonded at positions 5 and 7 (or at positions roughly equivalent to positions 5 and 7), respectively, for quinoline groups, quinazoline groups, coumarin groups, and chromone groups. They can be bonded at positions 2 and 4 (or positions roughly equivalent to positions 2 and 4), respectively, for pteridine groups. They can be bonded at positions 1 and 9 (or positions roughly equivalent to positions 1 and 9), respectively, for 1,4-benzodiazepine. By way of example, they can be bonded at positions 1 and 3, positions 2 and 4, positions 5 and 7, or positions 6 and 8 (or positions roughly equivalent to these positions) for acrylidine groups, phenoxazine groups, and phenothiazine groups. Binding L¹ and L² at these positions, as set forth above, makes it possible to obtain a compound in which the angle of the bend formed by L¹ and L² in the molecule with Ar in the center is around 120° (for example, falling within a range of 90 to 150°).

An example of an aromatic hydrocarbon group is an optionally fused aromatic hydrocarbon group comprising 6 to 14 carbon atoms.

An example of a single-ring aromatic hydrocarbon group is a substituted or unsubstituted phenylene group in the form of a compound in which L¹ and L² are bonded at the m positions (1 and 3 positions) of the phenylene group. By having L¹ and L² bonded at the m positions (1 and 3 positions) of the phenylene group, as set forth above, it is possible to obtain a compound in which the angle of the bend formed by L¹ and L² in the molecule with Ar (the phenylene group) in the center is around 120°.

Examples of multiple-ring aromatic hydrocarbon groups are substituted and unsubstituted naphthalene groups in which L¹ and L² are bonded at the m positions (1 and 3 positions) or 2 and 7 positions of the naphthalene group. Examples of other multiple-ring-type aromatic hydrocarbon groups are substituted and unsubstituted anthracene groups and substituted and unsubstituted phenanthroline groups in the form of compounds in which L¹ and L² are bonded either at positions 1 and 3 or at positions 2 and 7 of the anthracene group, or are bonded at positions 1 and 3 or at positions 3 and 6 of the phenanthroline group. By bonding L¹ and L² at these positions, as set forth above, it is possible to obtain a compound in which the angle of the bend formed by L¹ and L² in the molecule with Ar in the center is around 120° (for example, falling within a range of 90 to 150°).

The optional substituents on the aromatic heterohydrocarbon groups and aromatic hydrocarbon groups are not specifically limited. Examples are C₁₋₆ alkyl groups, C₁₋₆ perfluoroalkyl groups, alkoxy groups, siloxy groups, and dialkylamino groups. Examples of C₁₋₆ alkyl groups are methyl, ethyl, propyl, isopropyl, butyl, isobutyl, sec-butyl, tert-butyl, pentyl, and hexyl groups. Examples of C₁₋₆ perfluoroalkyl groups are trifluoromethyl, pentafluoroethyl, heptafluoropropyl, and tridecafluorohexyl groups. Examples of siloxy groups are trimethylsiloxy, triethylsiloxy, triisopropylsiloxy, and tert-butyldimethylsiloxy. Examples of alkoxy groups are C₁₋₆ alkoxy groups. Examples of C₁₋₆ alkoxy groups are methoxy groups, ethoxy groups, and hexyloxy groups. Examples of dialkylamino groups are dimethylamino and diethylamino groups. The substitution positions and number of substituents are not specifically limited.

Three examples of the compound denoted by general formula (7) uses in Reference examples will be given below. The angle of the bend formed by L₁ and L₂ within the molecule with Ar in the center within each compound will also be given. The angle of the bend is 144° in Compound 7-1 (Compound 4 of Reference Example 1-3), and 120° in Compound 7-2 (Compound 6 of Reference Example 1-4) and Compound 7-3 (Compound 10 of Reference Example 1-5).

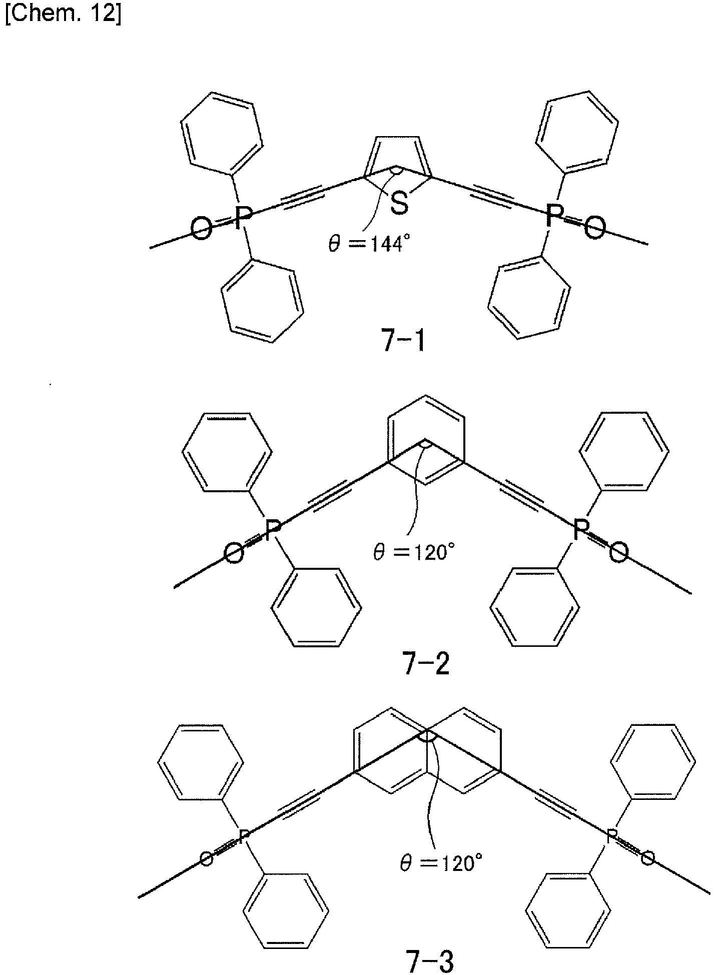

Each of L¹ and L² independently denotes a linker. Examples of linkers are -C≡C-, -CH=CH-, aromatic hydrocarbon groups, and aromatic heterohydrocarbon groups. The aromatic hydrocarbon groups and aromatic heterohydrocarbon groups are identical to the groups set forth above.

Each of X¹ and X² independently denotes a modified phosphoryl group denoted by O=P(Ar¹¹ Ar¹²)-. Each of Ar¹¹ and Ar¹² independently denotes a substituted or unsubstituted aryl group, substituted or unsubstituted heteroaryl group, or substituted or unsubstituted aralkyl group.

The aryl group of the optionally substituted aryl group is not specifically limited. Examples are C₆₋₂₀ aryl groups. Examples of C₆₋₂₀ aryl groups are phenyl, 1-naphthyl, 2-naphthyl, biphenylyl, and anthryl groups.

The substituent of the optionally substituted aryl group is not specifically limited. Examples are C₁₋₆ alkyl groups, C₁₋₆ perfluoroalkyl groups, C₆₋₁₄ aryl groups, 5 to 10-membered aromatic heterocyclic groups, alkoxy groups, aryloxy groups, siloxy groups, and dialkylamino groups.

The C₁₋₆ alkyl groups, C₁₋₆ perfluoroalkyl groups, alkoxy groups, siloxy groups, and dialkylamino groups are identical to the groups described for the optional substituents of the above aromatic heterohydrocarbon groups and aromatic hydrocarbon groups.

Examples of the C₆₋₁₄ aryl groups are phenyl, 1-naphthyl, 2-naphthyl, biphenylyl, and 2-anthryl groups. Examples of 5 to 10-membered aromatic heterocyclic groups are 2 or 3-thienyl; 2, 3, or 4-pyridyl; 2, 3, 4, 5, or 8-quinolyl; 1, 3, 4, or 5-isoquinolyl; 1, 2, or 3-indolyl; 2-benzothiazolyl; 2-benzo[b]thienyl, and benzo[b]furanyl groups.

Examples of aryloxy groups are C₆₋₁₂ aryloxy groups. Examples of C₆₋₁₂ aryloxy groups are phenoxy groups and naphthyloxy groups.

Neither the position nor number of substituents of the optionally substituted aryl groups is specifically limited.

The heteroaryl group of the optionally substituted heteroaryl group is not specifically limited. Examples are optionally fused, 5 to 14-membered, aromatic heterocyclic groups containing 1 to 3 atoms selected from the group consisting of sulfur atoms, oxygen atoms, and nitrogen atoms.

Examples of the aromatic heterocyclic group are furyl, thientyl, pyrrolyl, pyrazolyl, imidazolyl, oxazolyl, isoxazolyl, isothiazolyl, thiazolyl, 1,2,3-oxadiazolyl, triazolyl, tetrazolyl, thiadiazolyl, pyridyl, pyridazinyl, pyrimidinyl, pyrazinyl, indolyl, indazolyl, purinyl, quinolyl, isoquinolyl, phthalazinyl, naphthyridinyl, quinoxalinyl, quinazolinyl, cinnolinyl, pteridinyl, carbazolyl, carbolinyl, phenanthridinyl, and acridinyl groups.

The substituents of the optionally substituted heteroaryl group are the same as the substituents set forth above for the optionally substituted aryl group.

The position and number of the substituents of the optionally substituted heteroaryl group are not specifically limited.

Examples of the aralkyl group of the optionally substituted aralkyl group are benzyl groups, phenethyl groups, and phenylpropyl groups.

The substituents of the optionally substituted aralkyl group are identical to the substituents set forth for the optionally substituted aryl group.

The position and number of the substituents of the optionally substituted aralkyl group are not specifically limited.

By way of example, X¹ and X² can be diphenylphosphoryl groups in which Ar¹¹ and Ar¹² are phenyl groups.

### <The compound manufacturing method>

In the compound denoted by general formula (7), as exemplified in the Examples, X-Ar-X (X denoting a halogen) is employed as the starting compound. This is reacted with trialkylsilylacetylene in the presence of a catalyst (such as CuI and Pd(PPh₃)Cl₂, PPh₃). The product obtained is treated with an alkali, yielding diacetyl Ar. The diacetyl Ar obtained is reacted with a modified phosphine chloride, such as diphenylphosphine chloride. Subsequently, for example, hydrogen peroxide is used for oxidation and the modified phosphine group is replaced with a modified phosphoryl group (such as diphenylphosphoryl) to obtain the compound denoted by general formula (7). The various reactions can be conducted in suitable organic solvents (such as diethyl ether, tetrahydrofuran (THF), or toluene). When the linker is an ethylene group, the use of trialkylsilylethylene instead of trialkylsilylacetylene makes it possible to obtain the compound denoted by general formula (7) by the same reactions.

The starting compound denoted by X-Ar-X (X denoting a halogen) is available in the form of commercial products. It can also be obtained by halogenating by known methods a compound denoted by H-Ar-H, that is, X denotes a halogen atom. Trialkylsilylacetylene is available as a commercial product in the form of trimethylsilylacetylene, for example. The modified phosphine chloride is also available as a commercial product in the form of diphenylphosphine chloride, for example. Other modified phosphine chlorides can be suitably synthesized by the usual methods. Synthesized compounds can be suitably purified by known methods.

### <Phosphine oxide tridentate ligands>

An example of a polydentate ligand having a phosphine oxide group is the phosphine oxide tridentate ligand denoted by formula (8) below. The phosphine oxide compound of general formula (8) is either a known compound or a compound that can be prepared by a known method. 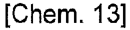 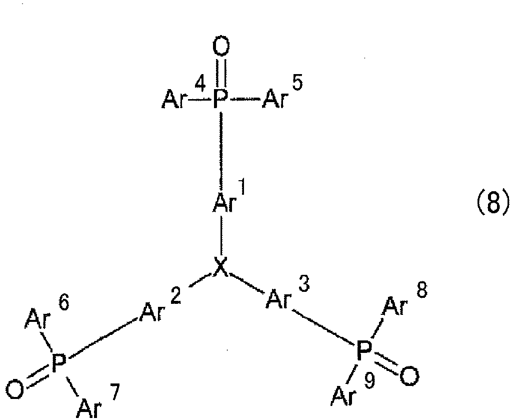 (in general formula (1), X denotes an atom having three-fold symmetry in a plan view of the structural formula containing the connectors of the atom, or a group of atoms having three-fold symmetry in a plan view of the chemical structural formula; and
each of Ar¹ to Ar⁹ independently denotes an aryl group which may comprise one or more substituents;
Ar⁴ and Ar⁵, Ar⁶ and Ar⁷, and Ar⁸ and Ar⁹, respectively, may form a phosphorus-containing hetero ring by binding);

In general formula (8), X denotes an atom having three-fold symmetry in a plan view of the structural formula containing the connectors of the atom, or a group of atoms having three-fold symmetry in a plan view of the chemical structural formula. Examples of atoms having three-fold symmetry in a plan view of the structural formula containing the connectors of the atom are aluminum, boron, germanium, and nitrogen (which contains an unshared electron pair but has C3 symmetry). Examples of groups of atoms having three-fold symmetry in a plan view of the chemical structural formula are an aryl group which may comprise one or more substituents and a heteroaryl group which may comprise one or more substitutents. The number of carbon atoms of the aryl group and heteroaryl group contained in the group of atoms is not specifically limited; 3 to 6 is desirable. The heteroaryl group contains hetero atoms selected from the group consisting of sulfur atoms, oxygen atoms, and nitrogen atoms. The number of hetero atoms varies suitably with the size of the heteroaryl group. For example, for a single ring, it will be 1 to 3, and for a fused ring (when two or more rings are present), it will be 1 to 3 per ring. From the perspective of having three-fold symmetry in a plan view of the chemical structural formula, specific examples of the group of atoms are phenyl groups and monocyclic six-membered heteroaryl groups. Examples of six-membered heteroaryl groups are pyridine rings, pyrmidine rings, and triazine rings.

Each of Ar¹ to Ar⁹ independently denotes a hetero aryl group or an aryl group which may comprise one or more substituents. The hetero aryl group and the aryl group are the same as the hetero aryl group and the aryl group in the group of atoms of the examples of the X. Ar¹ to Ar⁹ desirably denote phenyl groups which may comprise one or more substituents, and preferably denote phenyl groups.

A specific example of the phosphine oxide compound denoted by general formula (8) is at least one compound selected from the group consisting of (8-1) to (8-5) below:

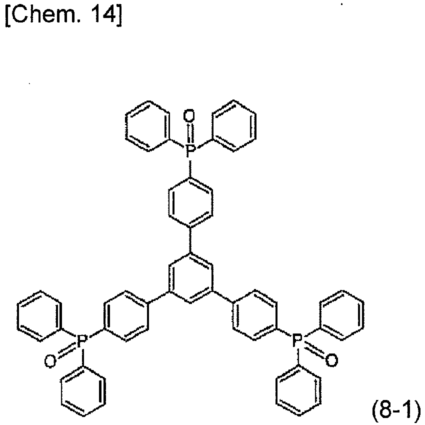

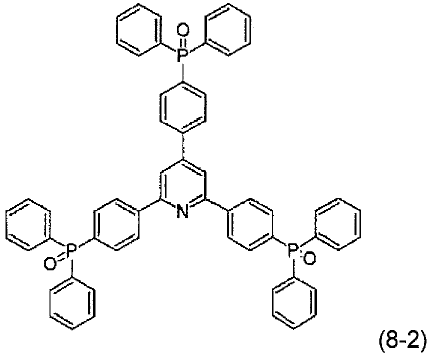

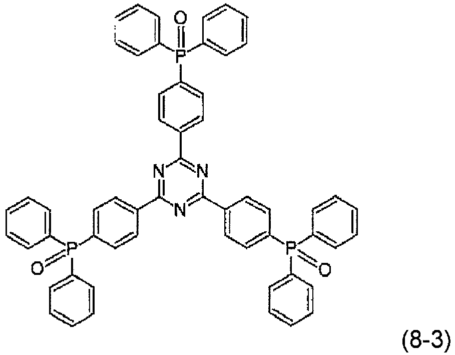

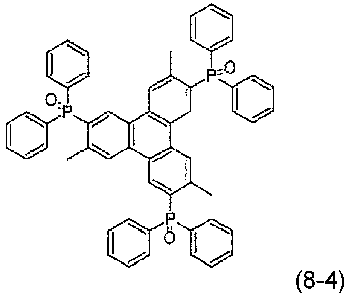

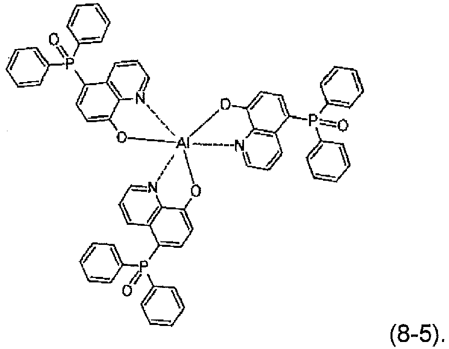

The phosphine oxide compound of general formula (8) is available in the form of commercial products. In addition, it can be synthesized by using oxidation of tertiary phosphine; reaction of phosphinyl chloride or phosphoryl dichloride with a Grignard reagent; coupling of a halogenated aryl and a diaryl phosphine oxide; hydrolysis of dihalophosphorane; or any other known method. Reference can be made to the following literature with regard to synthesizing the phosphine oxide compound of general formula (8):
[1] M. Stol, D. J. M. Snelders, H. Kooijman, A. L. Spek, G. P. M. Klink and G. Koten, Dalton Trans., 2007, 2589-2593.
[2] I. O. Koshevoy, L. Koskinen, E. S. Smirnova, M. Haukka, T. A. Pakkanen, A. S. Melnikov, and S. P. Tunik, Z. Anorg. Allg. Chem. 2010, 636, 795-802.

The polydentate ligand can be at least one compound selected from the group consisting of compounds having 2 or more pyridyl groups, compounds having 2 or more carboxylic acid groups, and compounds having 2 or more ester groups.

Examples of compounds having 2 or more pyridyl groups, compounds having 2 or more carboxylic acid groups, and compounds having 2 or more ester groups are the aromatic compounds denoted by formula (9):
[Chem. 15]

Ar-(X-Y)ₙ (9)

In the formula, Ar denotes a structure having an aromatic ring. X denotes a divalent organic group or a single bond directly connecting Ar and Y. Y denotes a group of atoms containing a coordinating atom. By way of example, Y is a pyridyl group, carboxylic acid group, or ester group, and n denotes an integer of from 2 to 6. The multiple instances of X that are contained within the molecule can be mutually different, and the multiple instances of Y can be mutually different.

In formula (9), Ar comprises a π plane forming a pseudo-planar structure. Ar is not specifically limited. It can be suitably selected taking into account the fact that the molecular size of the ligand affects to some degree the size of the first pore formed in the starting complex. Specific examples are single aromatic rings, particularly six-membered aromatic rings; and 2 to 5-ring fused multiple-ring aromatic rings, particularly fused multiple-ring aromatic rings in which 2 to 5 six-membered aromatic rings are fused.

To facilitate synthesis, a single aromatic ring in the form of a six-membered aromatic ring is desirably employed as Ar. Examples of single six-membered aromatic rings are: benzene rings, triazine rings, pyridine rings, and pyrazine rings. It suffices for Ar to have an aromatic ring structure. It is possible for an alicyclic ring structure to be contained in some portion, and for hetero atoms to be contained in the ring. It is also possible for substituents other than -(X-Y) to be present.

In Formula (9), it suffices to select the length of the chain of X, as a divalent organic group, that is sandwiched between Ar and Y to suit the required size of the first pore formed in the starting complex. Examples are divalent aliphatic groups with 2 to 6 carbon atoms, divalent six-membered single-ring aromatic rings, and fused multiple-ring aromatic rings in which 2 to 4 six-membered aromatic rings are fused. Here, the aromatic ring can containing hetero atoms within the ring and can comprise substituents. The aliphatic ring can have a branched structure, can contain unsaturated bonds, and can comprise hetero atoms.

Specific examples of the above divalent organic groups are phenylene groups, thiophenylene groups, furanylene groups, and other single-ring aromatic rings; fused multiple ring aromatic rings in which naphthyl groups, anthracene, and other benzene rings are fused; aliphatic groups such as acetylene groups, ethylene groups, amide groups, and ester groups; and groups having structures in which these groups are linked in any number and sequence. The multiple instances of X in a single molecule can be identical or different. Normally, from the perspective of facilitating synthesis, they are desirably identical.

Y is a group of atoms that is capable of coordinating with the central metal ion serving as the central metal. It is not specifically limited beyond that it be able to form a three-dimensional network structure by coordinating with the central metal ion. Examples are the groups denoted by (10) below.

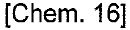

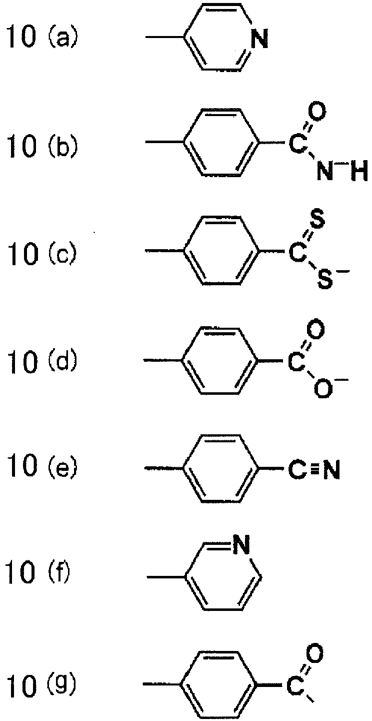

For example, Y is a group of atoms in the form of the 4-pyridyl group 10(a) containing a coordinating atom (N). In order for the lone pair of electrons present in the coordinating atom of Y to produce a suitable coordinating force in the course of coordination bonding with the central metal ion, pyridyl groups (10(a) and 10(f)) are preferred among the above formulas. The multiple instances of Y that are contained within a single molecule can be identical or different.

Among the above, desirable examples are aromatic rings in which X denotes a single bond directly linking Ar and Y in the form of single-ring aromatic rings such as phenylene rings, and fused multiple-ring aromatic rings such as naphthyl groups and anthracene; aliphatic groups such as acetylene groups and ethylene groups; and structures in which these groups are linked in any number and sequence. When -(X-Y) has a structure comprising an aromatic ring, acetylene group, or ethylene group, or a structure in which these are linked, axial rotation is limited by steric hindrance. Further, in a structure comprising an aromatic ring, acetylene ring, or ethylene ring, when π electrons form a delocalized conjugated system, the energy barrier of the conformation also limits axial rotation. Accordingly, the aromatic compound ligand denoted by formula (9) can be integrated to constitute a pseudo-planar structure, making it possible to form a stable, three-dimensional network structure.

From the perspective of facilitating design of the starting complex, the coordinating atom denoted by Y or the coordinating atom contained in Y desirably comprises a lone pair of electrons in the direction of extension of the axis of -(X-Y) having the above rigid linear structure. The number of -(X-Y) that are bonded to Ar depends on the structure of Ar. However, this number is normally 3 to 6. Further, -(X-Y) is desirably bonded to Ar such that the coordinating atoms are disposed radially and are roughly equally spaced within a single plane.

Examples of aromatic compound ligands having structures in which coordinating atoms are disposed radially and equally spaced in the direction in which extends the plane formed by the π conjugated system of the aromatic ring in the center of an aromatic ring-containing structure are denoted by formulas 9-1 to 9-4 below. Of the ligands given below, 2,4,6-tris(4-pyridyl)-1,3,5-triazine (formula 9-1) is employed with preference.

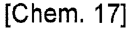

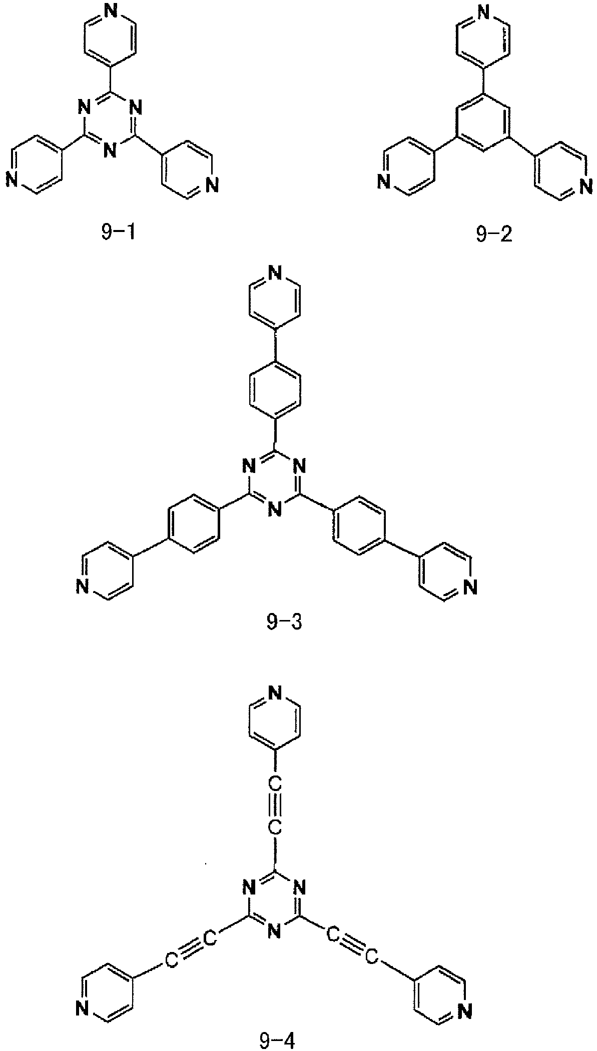

The above compound having two or more pyridyl groups as polydentate ligands is described, for example, in: (1) Acc. Chem. Res. 2005, 38, 371-380; (2) J. Am. Chem. Soc. 2011, 133, 13317-13319; (3) Japanese Unexamined Patent Publication (KOKAI) No. 2005-255545; (4) Japanese Unexamined Patent Publication (KOKAI) No. 2005-75751; (5) Japanese Unexamined Patent Publication (KOKAI) No. 2008-214318; and (6) Japanese Unexamined Patent Publication (KOKAI) No. 2010-180307.

The following compounds, described in above-cited Reference (2), are specific examples.

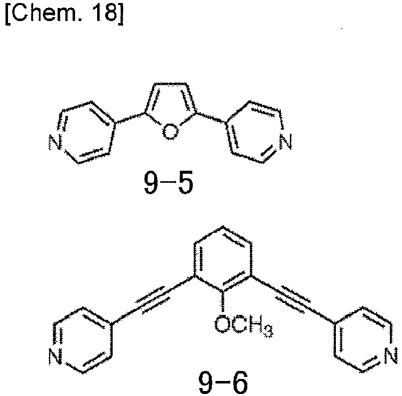

Examples of the above polydentate ligands in the form of compounds having two or more carboxylic acid groups are described in Chem. Soc. Rev., 2011, 40, 926-940. Specific examples of compounds having two or more carboxylic acid groups are given below.
H2bdc 1,4-Benzenedicarboxylic acid
H6bhc Benzenehexacarboxylic acid
H2bpdc 4,4-Biphenyldicarboxylic acid
H3btc 1,3,5-Benzenetricarboxylic acid
H3-1,2,4-btc Tri(methylammonium)benzene-1,2,4-tricarboxylic acid
H4btcb 1,2,4,5-Benzenetetracarboxylic acid
H3cit Citric acid
H2cmp N-(Carboxymethyl)iminodi(methylphosphonic acid)
H2damp Dimethylaminomethylphosphonic acid
H4EDTA Ethylenediaminetetraacetic acid
H2fum Fumaric acid
H5hedp Etidronic acid
H2hpd 4-Hydroxylpyridine-2,6-dicarboxylic acid
H3idc Imidazole-4,5-dicarboxylic acid
H6muc Mucic acid
H3mpaa 2-[Methyl(phosphonomethyl)amino]acetic acid
H2ndc 1,4-Naphthalenedicarboxylic acid
H2nds Naphthalenedisulfonic acid
H2oba 4,4-Oxybis(benzoic acid)
H2ox Oxalic acid
H2pdc Pyridine-3,5-dicarboxylic acid
H2PhenDCA 1,10-Phenanthroline-2,9-dicarboxylic acid
H2pvdc 4,4-[(2,5-Dimethoxy-1,4-phenylene)-di-2,1-ethenediyl]bisbenzoic acid
H2pza 2,3-Pyrazinedicarboxylic acid
H2pdca 2,3-Pyridinedicarboxylic acid
H2pydc 2,6-Pyridinedicarboxylic acid
H2tart Tartaric acid
H3tda 1H-1,2,3-Triazole-4,5-dicarboxylic acid
H2tdc Thiophene-2,5-dicarboxylic acid
H4teta 1,4,8,11-Tetraazacyclotetradecane-1,4,8,11-tetraacetic acid

Examples of polydentate ligands in the form of compounds having two or more ester groups are described in Inorg. Chem. 2012, 49, 9300-9311. Specific examples are 1,4-diacetylbenzene (acbz), 1,4-diacetoxybenzene (acetbz), and 1,4-dimethyl terephthalate (dmtph).

Micelle-containing solution B can be a solvent (continuous phase) in the form of water or an aqueous solution, containing particles containing polydentate ligands and a ferrocenyl surfactant. An organic solvent can be employed in combination with the particles containing polydentate ligands and a ferrocenyl surfactant. In the same manner as with micelle-containing solution A, the aqueous solution can contain a material that is capable of becoming an electrolyte in electrolysis, described farther below. Inorganic salts are examples of materials that are capable of becoming electrolytes. Examples of inorganic salts are halides of alkali salts such as LiBr, LiCl, NaCl, NaBr, KBr, KCI, NaClO₄, and LiClO₄. The organic solvent is desirably a solvent in which the polydentate ligands are highly soluble, such as diethyl ether, dimethoxy ethane, acetonitrile, dichloromethane, DMSO, or THF.

The content of polydentate ligands and ferrocenyl surfactant can be suitably determined by taking into account the fact that micelles containing polydentate ligands and ferrocenyl surfactant are being formed, and the micelle particle diameter that is suited to mixing of the micelles and formation of a thin film by electrolysis, described farther below. An example of a micelle particle diameter that is suited to mixing micelles and forming a thin film by electrolysis is an average diameter of less than or equal to 500 nm. The average particle diameter of micelle-containing solution B is desirably 10 to 500 nm, preferably 20 to 400 nm, more preferably 30 to 300 nm, still more preferably 40 to 200 nm, and yet still more preferably, falls within a range of 50 to 150 nm. The diameter of the micelles depends primarily on the quantity of organic solvent (when used) and the quantity of ferrocenyl surfactant. These quantities can be adjusted to control the average particle diameter of the micelles.

The concentration of the polydentate ligands in micelle-containing solution B falls within a range of 0.01 to 100 mM, for example. It can be suitably determined by taking into account achieving a micelle particle diameter that is suited to mixing the micelles and forming a thin film by electrolysis, described farther below.

The quantity of ferrocenyl surfactant can be suitably determined by taking into account the quantity of polydentate ligands and the quantity of organic solvent (when employed). The quantity of organic solvent (when employed) can be suitably determined by taking into account the quantity of polydentate ligands and the quantity of ferrocenyl surfactant. When adopting the quantity of polydentate ligands as a reference, the molar ratio of polydentate ligands to ferrocenyl surfactant (polydentate ligands : ferrocenyl surfactant) falls within a range of 1:0.1 to 10, for example. When adopting the quantity of polydentate ligands as a reference, the quantity of organic solvent (when used) can be a ratio of polydentate ligands (mols in mmol) to organic solvent (volume in mL) (polydentate ligands (mols in mmol) : organic solvent (volume in mL)) falling within a range of 1:0.1 to 10.

Micelle-containing solution B can be prepared by stirring and mixing the polydentate ligands, a ferrocenyl surfactant, and an organic solvent (when used). This operation can be conducted at room temperature (for example, at 10 to 30°C). The stirring and mixing conditions are not specifically limited. For example, they can be 1 to 180 minutes at 100 to 1,000 rpm.

Micelle-containing solution A and micelle-containing solution B are mixed to form a solution containing a mixture of micelles. The mixing ratio of micelle-containing solution A and micelle-containing solution B is suitably determined by taking into account the type and quantity (concentration) of the rare earth complex contained in micelle-containing solution A and the type and quantity (concentration) of the polydentate ligands contained in micelle-containing solution B, and by taking into account the type of rare earth complex polymer being targeted. Micelle-containing solution A and micelle-containing solution B are stirred and mixed. The stirring and mixing conditions are not specifically limited. By way of example, they can be 1 to 180 minutes at 100 to 1,000 rpm.

The formation of the mixed micelle-containing solution in step (1) can be conducted by mixing micelle-containing solutions A and B and then letting the mixed solution stationary for 0 to 48 hours, for example. By letting the mixed solution stationary after mixing micelle-containing solutions A and B, a mixture of micelles is formed. In the mixture of micelles that is formed, a reaction takes place between the rare earth complex and the polydentate ligands. After having stood, the mixture of micelles is subjected to electrolysis in step (2). The mixed solution can be left standing at any temperature - for example, this can be conducted within a range of -30 to 80°C. The average diameter of the mixture of micelles that has been left standing will normally be greater than the average diameter of micelle-containing solutions A and B prior to being mixed.

### <Step 2>

In step (2), the mixed micelle-containing solution that was adjusted in step (1) is electrolyzed as an electrolyte. This electrolysis is conducted to form a thin film of rare earth complex polymer containing the rare earth complex and polydentate ligands on the anode surface.

Various base materials on which it is desirable to form a thin film of rare earth complex polymer can be employed as the anode (electrode). The thin film of a rare earth complex polymer is employed as a light-emitting element comprising an electrode and a thin film of a rare earth complex polymer provided on the surface of the electrode, or as an organic EL device comprising this light-emitting element. Thus, the electrode is desirably one that is suitable for use as a light-emitting element or an organic EL device. For example, a transparent electrode is desirable as the electrode. The thin film of a rare earth complex polymer can be formed over the entire surface of the anode (electrode). However, existing masking techniques can be employed to form a thin film of rare earth complex polymer over just a desired region.

The electrolysis is desirably conducted while controlling the potential of the anode to a potential suited to breaking down the micelles by electrochemical oxidization of the ferrocenyl surfactant contained in the mixed micelle-containing solution. Thus, the use of constant potential electrolysis permitting electrolysis while controlling the potential of the anode is desirable. By causing the ferrocenyl surfactant to be electrochemically oxidized and causing the micelles to break down, it is possible to form a thin film of a rare earth complex polymer on the electrode. By controlling the duration of electrolysis, concentration of micelles, and the like, it is possible to control the film thickness of the thin film of rare earth complex polymer. The temperature and duration of electrolysis can be suitably determined by taking into account the thickness of the thin film, the reactivity of the micelles, and the like.

The thickness of the thin film of rare earth complex polymer that is formed is not specifically limited. By way of example, it falls within a range of 1 to 1,000 nm. However, there is no intent to exclude film thicknesses that exceed this range. The thickness of the thin film can be suitably varied by controlling the duration of electrolysis.

The rare earth complex polymer that is formed by the method of the present invention is a polymer that contains a crosslinked structure of the rare earth complex and the polydentate ligands. The repeating unit of the polymer and its steric structure will depend on the types and quantity ratio of the rare earth complex and the polydentate ligands employed. When the polydentate ligands are bidentate ligands, a linear polymer will be formed. When tridentate or higher ligands are employed, a polymer having a three-dimensional structure will be formed. In the case where the polydentate ligands are a mixture of bidentate ligands and tridentate or higher ligands, a linear polymer having three-dimensional structures in portions will be formed.

### [The light-emitting element]

The present invention includes a light-emitting element comprising an electrode and a thin film of a rare earth complex polymer formed by the method of the present invention provided on the surface of the electrode.

The electrode is desirably one that lends itself to use of the light-emitting element as an organic EL device. For example, it is desirably a transparent electrode. The thin film of rare earth complex polymer is a thin film of a rare earth complex polymer manufactured by the manufacturing method of the present invention.

### [The organic EL device]

The present invention includes an organic EL device comprising the light-emitting element of the present invention, an electron or hole transport layer on at least a portion of the surface of the thin film of the rare earth formed by the method of the present invention of the light-emitting element, and an electrode present on the electron or hole transport layer.

Specifically, the EL element can be comprised of a substrate, a transparent electrode (anode), a hole transport layer, a light-emitting layer, an electron transport layer, and a rear surface electrode (cathode). The light-emitting layer is comprised of the thin film rare earth complex polymer of the present invention. The thickness of the light-emitting layer is, for example, 10 nm to 5 µm, desirably 20 nm to 500 nm.

Examples of substrates are glass, plastic films, and thin metal films. The substrate can be present on just one side of an EL element, or can sandwich it on both sides. When substrates are disposed on both sides of the EL element, one of the substrates is desirably transparent. Materials such as indium tin oxide (ITO), In₂O₃, SnO₂, TiO₂, and ZnO can be employed as transparent electrodes (anodes). ITO is a desirable example. These transparent electrodes are normally used to form thin films by vacuum vapor deposition, sputtering, the sol-gel method, or the like. By way of example, the anode is 10 to 500 nm thick.

Amine compounds are employed as hole transport layers. Examples are TPD [bis-(3-methylphenyl)-N,N'-diphenylbenzidine, Appl. Phys. Lett., Vol. 57, p. 531, 1990]; phenylenediamine (US Patents 3,180,729 and 4,278,746; and Japanese Unexamined Patent Publication (KOKAI) Heisei No. 3-152897); triphenylamine (Japanese Unexamined Patent Publication (KOKAI) Showa No. 63-295695 and Japanese Unexamined Patent Publication (KOKAI) Heisei No. 3-152897). Hole transport layers are formed as thin films by the usual vapor deposition method, spincoating method, or the like. By way of example, the thickness thereof is 20 to 1,000 nm.

Normally PBD (2-[4-biphenylyl]-5-[4-tert-butylphenyl]-1,3,4-oxadiazole), nitro-substituted fluorenone derivatives, anthraquinone methane derivatives, diphenyl quinone derivatives, anthrone derivatives, and the like are normally employed in the electron transport layer. By way of example, the thickness is 20 to 1,000 nm.

Examples of the rear surface electrode (cathode) are lithium, aluminum, magnesium, and silver. To increase the contrast, a black electrode (Al-Ge, MnO₂) and the like can be employed. The thickness of the cathode is 10 to 500 nm, for example.

The EL element can be applied to displays, pilot lamps, EL lasers, automotive-use lamps such as rear combination lamps, and the like.

### [Examples]

The present invention will be described in greater detail below through examples. However, there is no intent to limit the present invention to the examples.

### Example 1

### Constant potential electrolysis of Eu(hfa)₃(H₂O)₂ + 4,4'-bis(diphenylphosphoryl)biphenyl mixed micelles

### 1) Formation of micelles containing Eu(hfa)₃(H₂O)₂

### Operation

A 20 mL quantity of an aqueous solution (1 mM-FePEG + 0.1M-LiBr) was prepared and 0.2 mL of diethyl ether in which had been dissolved Eu(hfa)₃(H₂O)₂ (0.04 mmol, 32.4 mg) with stirring at about 945 rpm was added. The mixture was stirred for 30 min to achieve dispersion in the solution. The Eu(hfa)₃(H₂O)₂ was prepared by the method indicated in Reference Example 1-1.

### 2) Formation of micelles containing 4,4'-bis(diphenylphosphoryl)biphenyl (dpbp) Operation

A 20 mL quantity of an aqueous solution (1 mM-FePEG + 0.1M-LiBr) was prepared and dpbp (33.3 mg, 0.06 mmol) was added with stirring at about 945 rpm. The mixture was stirred for 5 days and then centrifuged (2000 rpm, 1 h). The supernatant was removed to a separate vessel. The dpbp was prepared by the method indicated in Reference Example 1-2.

### 3) Constant potential electrolysis of mixed micelle solution

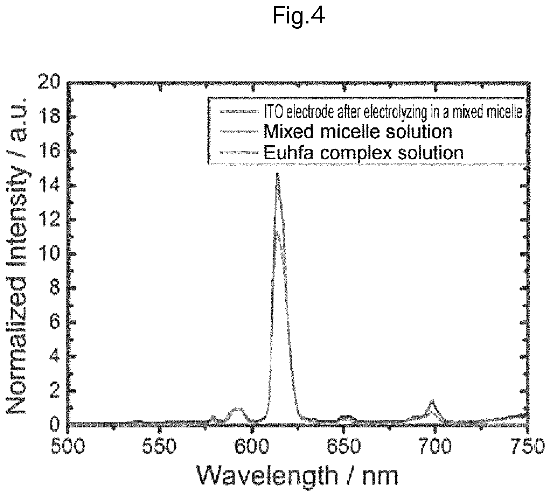

A 10 mL quantity of each of the micelle solutions prepared in 1) and 2) was mixed and the mixture was stirred for 30 minutes at about 945 rpm. The mixture was left standing for 1 day at room temperature. This mixed micelle solution was subjected to constant potential electrolysis under the following conditions using a three-electrode cell. The emission spectrum of the ITO electrode following electrolysis was measured. The results are given in Figure 4.

Counter electrode (CE): Pt
Reference electrode (RE): Ag/AgCl
Working electrode (WE): ITO electrode (8-10 Ω·cm⁻², electrode area: 1 cm²)
Electrolyte: 0.1M-LiBr
Stirring speed: about 60 rpm
Voltage: 1 V vs NHE
Duration of electrolysis: 18 hours

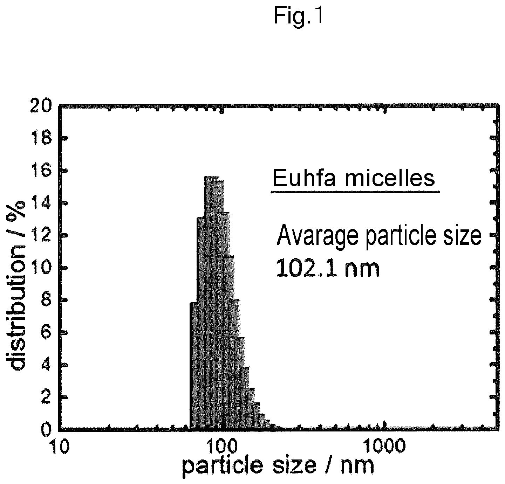

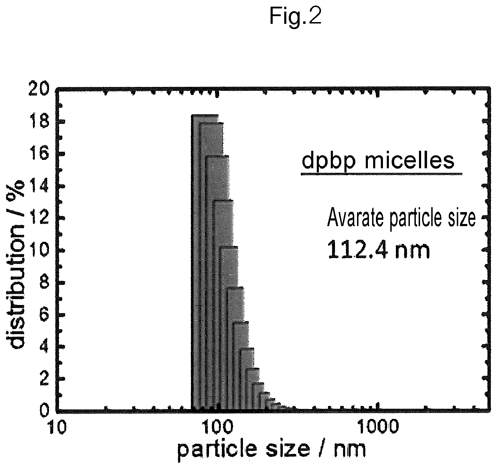

It will be understood from Figures 1 and 2 that the average particle diameters of Eu(hfa)₃ (H₂O)₂-containing micelles and dpbp-containing micelles were 102.1 and 112.4 nm, respectively. In the course of mixing solutions of these micelles, the particle size distribution of the micelles obtained exhibited the property of a monodispersion, and was found to be larger (170.0 nm) than the average particle size of the micelles prior to mixing. Thus, incorporating the respective micelle solution was thought to cause the micelles to stick together into a single type of micelle. By letting them stand in this state, the Eu(hfa)₃(H₂O)₂ and dpbp were caused to react.

Figure 4 shows the emission spectra of the mixed micelle solution, the ITO electrode following electrolysis of the mixed micelle solution, and the Eu(hfa)₃(H₂O)₂ solution. From these results, it will be understood that a spectrum was obtained from the mixed micelle solution that differed from the luminescence of Eu(hfa)₃(H₂O)₂. Since the emission spectrum of the ITO electrode following electrolysis of the mixed micelle solution matched the emission spectrum of the mixed micelle solution, the material in the micelle was thought to have formed a thin film on the ITO electrode.

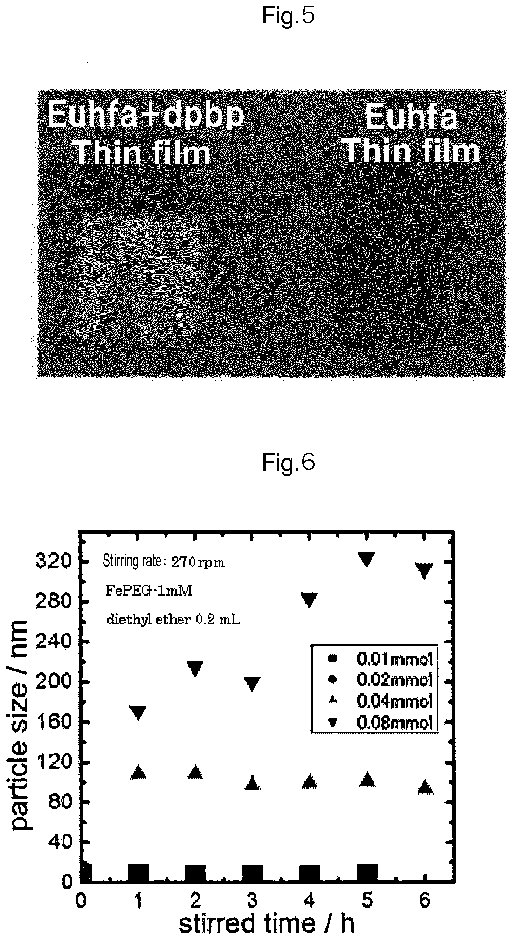

Figure 5 shows the ITO electrode (on right in figure) following electrolysis of the Eu(hfa)₃(H₂O)₂-containing micelles, and the ITO electrode (on left in figure) following electrolysis of the mixed micelles of the Eu(hfa)₃(H₂O)₂-containing micelles and dpbp-containing micelles. It was determined visually from the figure that the thin film obtained by electrolyzing the mixed micelles emitted red light when irradiated with UV.

### Reference Example 1-1. Synthesis of Eu(hfa)₃(H₂O)₂

Europium acetate (5 g, 15 mmol) was charged to a 100 mL beaker, about 30 mL of pure water was added, and the europium acetate was dissolved with stirring. The solution was transferred to an eggplant-shaped flask and a stirrer was introduced. Hfa (7.0 g, 33 mmol) was slowly added dropwise while stirring the solution on a magnetic stirrer. Following the dropwise addition, stirring was conducted for 2 hours. The precipitate was suction filtered and washed with chloroform. The powder obtained was placed in a sample bottle of known weight and vacuum dried for 1 hour. The weight was determined as the complex yield (7.17 g, yield: 59%).

### Reference Example 1-2. Synthesis of 4,4'-bis(diphenylphosphoryl)biphenyl (dpbp)

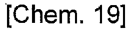

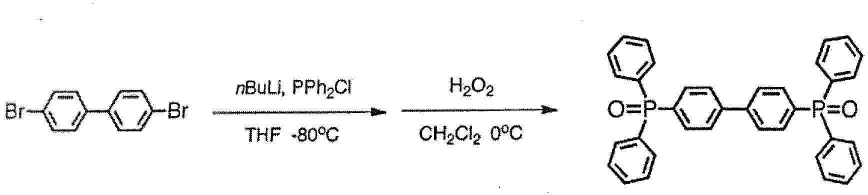

To a 4,4'-dibromobiphenyl (1.9 g, 6.0 mmol) solution (in dry THF (30 mL)) was added dropwise a n-BuLi solution (9.3 mL, 1.6 M hexane, 15 mmol) at -80°C and the mixture was stirred for 3 hours. Subsequently, PPh₂Cl (2.7 mL, 15 mmol) was added dropwise at -80°C. The methanol cooling vessel was detached and the mixture was gradually returned to room temperature with stirring for 14 hours. The product was extracted with ethyl acetate, washed three times with saturated brine, and dried with anhydrous MgSO₄. The solvent was evaporated off. The residue was washed several times with acetone and ethanol. The white solid obtained and about 40 mL of dichloromethane were charged to a flask and cooled to 0°C. A 5 mL quantity of 30% H₂O₂ aqueous solution was added and the mixture was stirred for 2 hours. The product was extracted with dichloromethane. The extract was washed three times with saturated brine and dried with anhydrous MgSO₄. The solvent was evaporated off, leaving a white powder. This was recrystallized from dichloromethane to obtain white crystals of dpbp.

Yield: 0.83 g (25%). IR (KBr): 1120 (st, P=O) cm⁻¹.¹H NMR (270 MHz, CDCl3, 25°C) δ 7.67-7.80 (m, 16H; P-C6H5, C6H4), 7.45-7.60 (m, 12H; P-C6H5, C6H4) ppm.

### Reference Example 1-3. Synthesis of 2,5-bis[(diphenylphosphoryl)ethynyl]thiophene (dpet) :4 (=Compound 7-1 above)

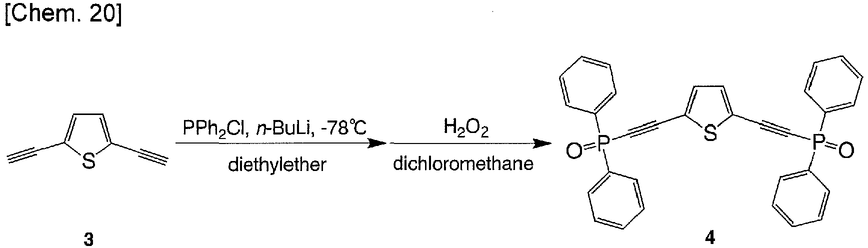

A 100 mL, three-necked flask was flame dried and then backfilled with Ar. To this were sequentially charged 2,5-diethynylthiophene (0.35 g, 2.65 mmol) (see D. G. Whitten et al., J. Phys. Chem., 2008, 112, 14492-14499) and diethyl ether (30.0 mL), and the mixture was stirred until rendered uniform. Liquid nitrogen was added to a methanol bath and the system cooled to -80°C, at which point 1.6 M n-BuLi (3.50 mL, 5.60 mmol) was added dropwise. The temperature was raised to -20°C over 3 hours, at which point liquid nitrogen was again added to cool the mixture to -80°C and PPh₂Cl (1.20 mL, 6.64 mmol) was added. Stirring was conducted for 4 hours to raise the temperature of the system to room temperature. Stirring was continued for 15 hours. When the stirring had ended, dichloromethane and saturated brine were used to extract the solution three times. Magnesium sulfate was added to the organic layer to dry it, and the solvent was distilled off in an evaporator. The brown, oily liquid obtained was added to a 300 mL eggplant-shaped flask and dissolved with dichloromethane. To this was added H₂O₂ (1.20 mL) and the mixture was stirred for 2 hours in an ice bath. When the stirring had ended, the solvent was distilled off in an evaporator. The residue obtained was purified by silica gel chromatography with a suitable developing solvent (dichloromethane:ethyl acetate = 1:1). A yellowish-green, oily liquid was obtained. When this had been left standing for about 15 minutes, yellow crystals precipitated.

Yield : 0.60 g (42.5 %)
¹H-NMR (270 MHz, CDCl₃, TMS): δ 7.47-7.62 (m, 6H, -CH), δ 7.82-7.91 (m, 4H, -CH), δ 7.35 (s, 1H, -CH)ppm. EI-MS(m/z) [M]⁺ = 533.09.

### Reference Example 1-4. Synthesis of 1,3-bis[(diphenylphosphoryl)ethynyl]benzene (dpeb) :6 (=Compound 7-2 above)

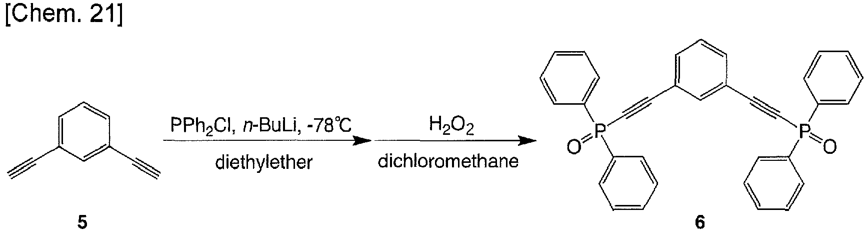

A 300 mL, three-necked flask was flame dried and then backfilled with Ar. To this were sequentially charged 1,3-diethynylbenzene (1.80 g, 14.2 mmol) and diethyl ether (70.0 mL). The solution was stirred until uniform. Liquid nitrogen was added to a methanol bath and the system was cooled to -80°C, at which point 1.6 M n-BuLi (19.6 mL, 31.4 mmol) was added dropwise. The temperature was raised to -20°C over 2.5 hours, liquid nitrogen was added again to cool the mixture to -80°C, and PPh₂Cl (5.80 mL, 31.4 mmol) was added. The temperature of the system was raised to room temperature over 4 hours, and stirring was continued for 15 hours. When the stirring had ended, dichloromethane and saturated brine were used to extract the solution four times. The solvent in the organic layer was distilled off in an evaporator. The orange, oily liquid obtained was added to a 300 mL eggplant-shaped flask and dissolved by adding dichloromethane. To this was added H₂O₂ (5.00 mL) and the mixture was stirred for 2 hours in an ice bath. When the stirring had ended, the solution was extracted four times with dichloromethane and saturated brine. Magnesium sulfate was added to the organic layer obtained to dry it, and the solvent was distilled off in an evaporator. The residue obtained was purified by silica gel chromatography with a suitable developing solvent (dichloromethane:ethyl acetate = 1:1), yielding a bright yellow, oily liquid. This was recrystallized with chloroform and hexane and thoroughly cleaned with ethyl acetate, yielding white acicular crystals.
Yield: 2.06 g (27.6%)

¹H-NMR (270 MHz, CDCl₃, TMS): *δ* 7.84-7.95 (m, 8H, -CH), δ 7.82 (s, 1H, -CH), δ 7.67-7.70 (d, 1H, -CH), δ 7.64-7.66 (d, 1H, -CH), δ 7.47-7.62 (m, 12H, -CH), δ 7.38-7.46 (t, 1H, -CH)ppm. EI-MS(m/z) [M]⁺ = 526.10. Anal. calcd for C₃₄H₂₄O₂P₂ : C, 72.17; H, 4.16 %. found : C, 72.31; H, 4.37 %.

### Reference Example 1-7. Synthesis of 2,7-bis[(diphenylphosphoryl)ethynyl]napthalene (dpen): 10 (=Compound 7-3 above)

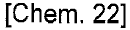

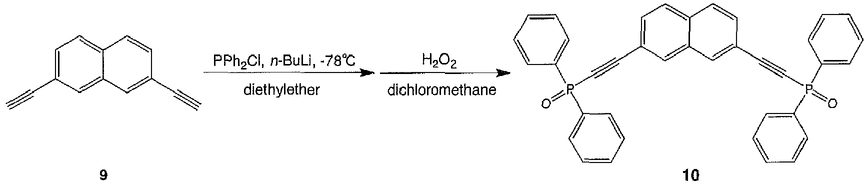

A 100 mL, three-necked flask was flame dried and then backfilled with Ar. To this were sequentially charged 2.7-diethynylnapthalene (see G. M. Whitesides et al., J. Org. Chem., 1988, 53, 2489-2496) and diethyl ether (20.0 mL). The solution was stirred until uniform. Liquid nitrogen was added to a methanol bath and the system was cooled to - 80°C, at which point 1.6 M n-BuLi (0.60 mL, 0.96 mmol) was added dropwise. The temperature was raised to -20°C over 3 hours, liquid nitrogen was added again to cool the mixture to -80°C, and PPh₂Cl (0.17 mL, 0.94 mmol) was added. The temperature of the system was raised to room temperature over 4 hours, and stirring was continued for 20 hours. When the stirring had ended, dichloromethane and saturated brine were used to extract the solution four times. The solvent in the organic layer was distilled off in an evaporator. The pale yellow, oily liquid obtained was charged to a 300 mL eggplant-shaped flask and dissolved with dichloromethane. To this was added H₂O₂ (1.00 mL) and the mixture was stirred for 2 hours in an ice bath. When the stirring had ended, the solution was extracted four times with dichloromethane and saturated brine. Magnesium sulfate was added to the organic layer obtained to dry it, and the solvent was distilled off in an evaporator. The residue obtained was purified by silica gel chromatography with a suitable developing solvent (hexane:ethyl acetate = 1:1), yielding a yellowish-green oily liquid.
Yield: Trace quantity that could not be measured

¹H-NMR (270 MHz, CDCl₃, TMS): δ 7.19 (s, 1H, -CH), δ 7.43-7.63 (m, 15H, -CH), δ 7.65-7.80 (m, 10H, -CH)ppm.

### 2. Controlling the state of the Eu(hfa)₃(H₂O)₂-containing FePEG micelles

The micelle particle diameter was controlled when the particle diameter of the micelles of ferrocenyl surfactant (FePEG) incorporating Eu(hfa)₃(H₂O)₂ formed under the following conditions was measured.

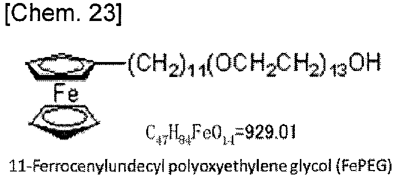

### Reference Example 2-1. The dependence of micelle particle diameter on Eu(hfa)₃(H₂O)₂ concentration, quantity of solvent, and FePEG concentration

A 20 mL quantity of aqueous solution (1 mM-FePEG + 0.1M-LiBr) was prepared and prescribed quantities of Eu(hfa)₃(H₂O)₂ (0.01, 0.02, 0.04, 0.08 mmol) were added while stirring at about 270 rpm. The particle diameters of the micelles that formed were measured once each hour with an ELSZ-1000 zeta potential and particle size analyzer. The quantity of Eu(hfa)₃(H₂O)₂ added was kept constant (32.4 mg, 0.04 mmol) while varying the quantity of diethyl ether and the FePEG concentration, and the particle diameter of the micelles was measured once each hour.

### < Change in quantity of Eu(hfa)₃(H₂O)₂ >

Figure 6 shows the results for the change in particle diameter of the micelles when the quantity of Eu(hfa)₃(H₂O)₂ added was varied at a constant stirring speed (about 270 rpm). From these results, it was understood that the particle diameter of the micelles changed with the quantity of Eu(hfa)₃(H₂O)₂ that was added. When the quantity of Eu(hfa)₃(H₂O)₂ was 0.01 mmol and 0.02 mmol, no change in the particle diameter of the micelles was observed comparing to at a stirring time of 0 hours, that is, prior to the Eu(hfa)₃(H₂O)₂ being incorporated by the FePEG. From this fact, the incorporation of Eu(hfa)₃(H₂O)₂ was thought to be precluded when the quantity of Eu(hfa)₃(H₂O)₂ added was small. For 0.04 mmol and 0.08 mmol, the incorporation of Eu(hfa)₃(H₂O)₂ was confirmed based on the change in particle diameter. The particle diameter increased with the quantity added. With the addition of 0.04 mmol, the particle diameter became constant at about 1 hour. With the addition of 0.08 mmol, the particle diameter was found to still not have become constant even after 6 hours.

### <Changes in FePEG concentration and oil layer quantity>

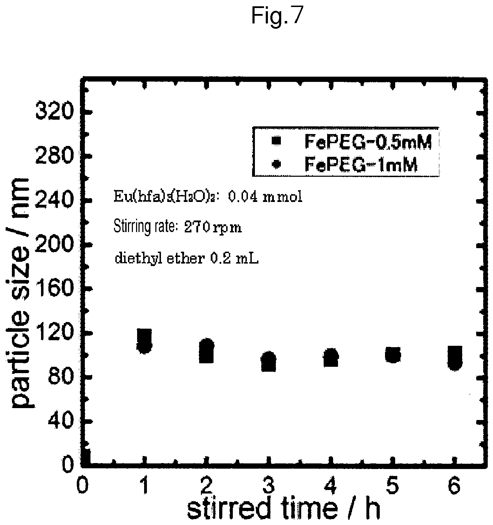

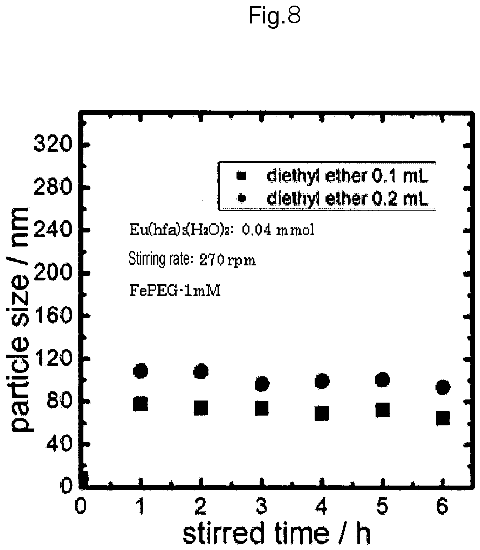

Figures 7 and 8 show the change in the particle diameter of the micelles with change in the FePEG concentration and the quantity of diethyl ether, respectively, with the addition of a constant quantity (32.4 mg, 0.04 mmol) of Eu(hfa)₃(H₂O)₂. Based on these results, the micelle particle diameter was found not to be dependent on the concentration of FePEG, but to be dependent on the quantity of diethyl ether serving as solvent for the Eu(hfa)₃(H₂O)₂. The dependence on the quantity of diethyl ether was found to be less than the effect due to the quantity of Eu(hfa)₃(H₂O)₂ added.

The above results are summarized below:
- The particle diameter of the micelles depended on the quantity of Eu(hfa)₃(H₂O)₂ and on the quantity of the solvent of the Eu(hfa)₃(H₂O)₂ in the form of diethyl ether.
- The dependence on the quantity of Eu(hfa)₃(H₂O)₂ added was greater than the dependence on the quantity of diethyl ether.
- The particle diameter of the micelles did not depend on the FePEG concentration.

### [Industrial Applicability]

The present invention is useful in the field of manufacturing devices containing rare earth complexes.

## Claims

1. A method for manufacturing a thin film of a rare earth complex polymer comprising the steps of:
(1) mixing a solution A containing micelles containing a rare earth complex and a ferrocenyl surfactant and a solution B containing micelles containing polydentate ligands and a ferrocenyl surfactant to form a solution containing a mixture of micelles;
(2) electrolyzing the solution containing a mixture of micelles as an electrolyte, forming a thin film of a rare earth complex polymer containing the rare earth complex and the polydentate ligands on an anode surface; wherein:
- the rare earth complex comprises a rare earth ion and a ligand denoted by formula (1) below coordinated with the rare earth ion: 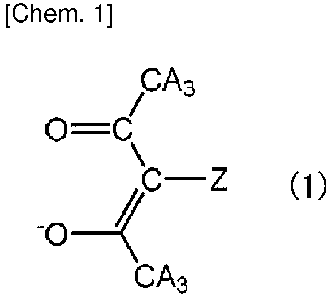 (in the formula, A denotes a hydrogen atom or a halogen atom and Z denotes a hydrogen atom or a deuterium atom);
- the polydentate ligand is a compound having two or more of at least one type coordinating functional groups to rare earth ion; and
- the rare earth compound polymer comprises a crosslinked structure of the polydentate ligand and rare earth complex.

2. The manufacturing method according to claim 1, wherein the mixture is left standing for 0 to 48 hours after mixing solutions A and B containing micelles in forming the solution containing a mixture of micelles in step (1), and then is subjected to electrolysis in step (2).

3. The manufacturing method according to claim 1 or 2, wherein solutions A and B containing micelles are formed so that the average diameter of the micelles is less than or equal to 500 nm.

4. The manufacturing method according to any one of claims 1 to 3, wherein the average diameter of the mixed micelles subjected to electrolysis in step (2) is greater than the average diameter of solutions A and B containing micelles prior to mixing.

5. The manufacturing method according to any one of claims 1 to 4, wherein the ferrocenyl surfactant is ferrocenyl polyethylene glycol.

6. The manufacturing method according to any one of claims 1 to 5, wherein the polydentate ligand is a compound comprising two or more of at least one coordinating functional group selected from the group consisting of phosphine oxide groups, pyridyl groups, carboxylic acid groups, and ester groups.

7. The manufacturing method according to any one of claims 1 to 5, wherein the polydentate ligand is the phosphine oxide bidentate ligand denoted by formula (2) below: 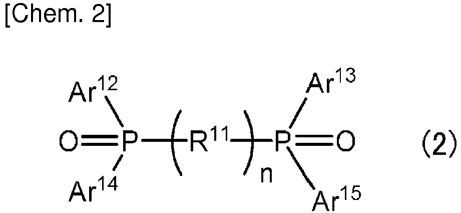 (in the formula, R¹¹ denotes a divalent organic group; each of Ar¹², Ar¹³, Ar¹⁴, and Ar¹⁵ independently denotes an optionally substituted monovalent aromatic group, it being possible for Ar¹² and Ar¹³, and Ar¹⁴ and Ar¹⁵, to be directly bonded together or bonded through connecting groups; and n denotes an integer of 1 to 20).

8. The manufacturing method according to claim 7, wherein R¹¹ is the group denoted by formula (3a) below, the group denoted by formula (3b) below, the group denoted by formula (3c) below, or the group denoted by formula (3d) below: 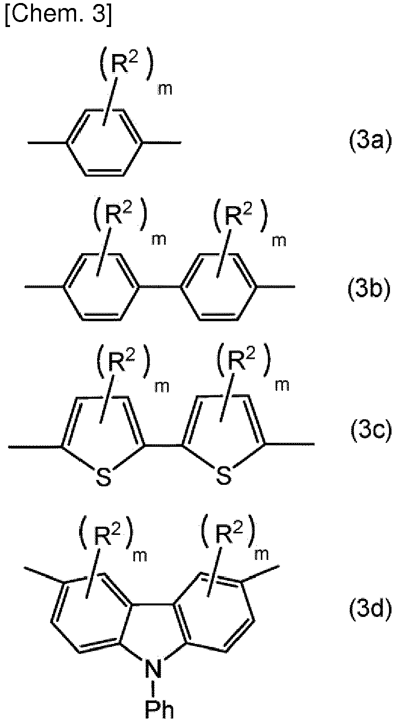 (in the formulas, R² denotes a monovalent organic group, m denotes an integer of from 0 to the number of sites permitting substitution on the ring to which R² is bonded; and Ph denotes a phenyl group; such that when m is greater than or equal to 2, the multiple instances of R² is identical or different).

9. The manufacturing method according to claim 8, wherein a single rare earth ion forms a coordination structure with a coordination number of greater than or equal to 8, in which a plurality of the phosphine oxide polydentate ligands are coordinated at a single site each with the rare earth ion, and a plurality of the ligand denoted by formula (1) are coordinated at two sites each with the rare earth ion.

## Patentansprüche

1. Ein Verfahren zur Herstellung eines dünnen Films eines Selten-Erd-Polymerkomplexes umfassend die Schritte:
(1) Mischen einer Lösung A aufweisend Mizellen beinhaltend einen Selten-Erd-Komplex und ein Ferrocenyl-Tensid und einer Lösung B aufweisend Mizellen beinhaltend polydentate Liganden und ein Ferrocenyl-Tensid um eine Lösung aufweisend eine Mischung von Mizellen zu erhalten;
(2) Elektrolysieren der Lösung welche eine Mizellenmischung aufweist als Elektrolyt, um einen dünnen Film eines Selten-Erd-Polymerkomplexes aufweisend den Selten-Erd-Komplex und die polydentaten Liganden auf einer Anodenoberfläche zu erhalten, wobei:
- der Selten-Erdkomplex ein Selten-Erd-Ion und einen Liganden nach untenstehender Formel (1) aufweist, welcher an das Selten-Erd-Ion koordiniert ist: 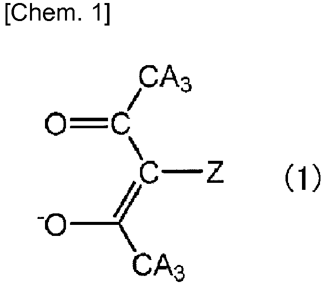 (in der Formel steht A für ein Wasserstoffatom oder ein Halogenatom, und Z steht für ein Wasserstoffatom oder ein Deuteriumatom);
- der polydentate Ligand ist eine Verbindung mit zwei oder mehr zum Selten-Erd-Ion koordinierenden funktionellen Gruppen wenigstens eines Typs; und
- die Selten-Erd-Polymerverbindung weist eine vernetzte Struktur des polydentaten Liganden und des Selten-Erdkomplexes auf.

2. Das Herstellverfahren nach Anspruch 1, wobei nach Mischen der Lösungen A und B aufweisend Mizellen im Schritt (1) um eine Lösung zu erhalten, welche eine Mischung der Mizellen aufweist, die Mischung für 0 bis zu 48 Stunden stehengelassen, und diese dann einer Elektrolyse im Schritt (2) unterworfen wird.

3. Das Herstellverfahren nach Anspruch 1 oder 2, wobei die Lösungen A und B aufweisend Mizellen so hergestellt werden, dass der durchschnittliche Durchmesser der Mizellen kleiner oder gleich 500 nm ist.

4. Das Herstellverfahren nach einem der Ansprüche 1 bis 3, wobei der durchschnittliche Durchmesser der Mizellen-Mischung, welche im Schritt (2) der Elektrolyse unterworfen wird, größer ist als der durchschnittliche Durchmesser der Lösungen A und B aufweisend Mizellen vor dem Mischen.

5. Das Herstellverfahren nach einem der Ansprüche 1 bis 4, wobei das Ferrocenyl-Tensid Ferrocenyl-Polyethylen-Glykol ist.

6. Das Herstellverfahren nach einem der Ansprüche 1 bis 5, wobei der polydentate Ligand eine Verbindung aufweisend zwei oder mehr wenigstens einer koordinierender funktioneller Gruppen ist, ausgesucht aus der Gruppe bestehend aus Phosphanoxid Gruppen, Pyridyl Gruppen, Carbonsäure Gruppen, und Ester Gruppen.

7. Das Herstellverfahren nach einem der Ansprüche 1 bis 5, wobei der polydentate Ligand der zwei-zähnige Phosphanoxid Ligand nach untenstehender Formel (2) ist: 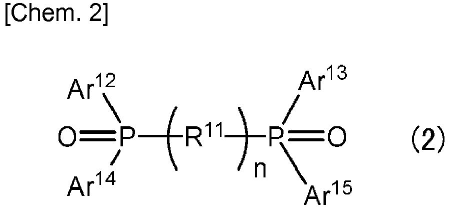 (in der Formel, steht R¹¹ für eine divalente organische Gruppe; jeder der Ar¹², Ar¹³, Ar¹⁴, und Ar¹⁵ steht unabhängig voneinander für eine optional substituierte monovalente aromatische Gruppe, es ist für Ar¹² und Ar¹³, und Ar¹⁴ und Ar¹⁵, möglich, dass diese direkt aneinander oder durch Verbindungsgruppen aneinandergebunden sind; und n steht für einen Integer von 1 bis 20).

8. Das Herstellverfahren nach Anspruch 7, wobei R¹¹ die Gruppe nach untenstehender Formel (3a) ist, die Gruppe (3b) unten angegeben ist, die Gruppe (3c) unten angegeben ist, oder die Gruppe (3d) unten angegeben ist: 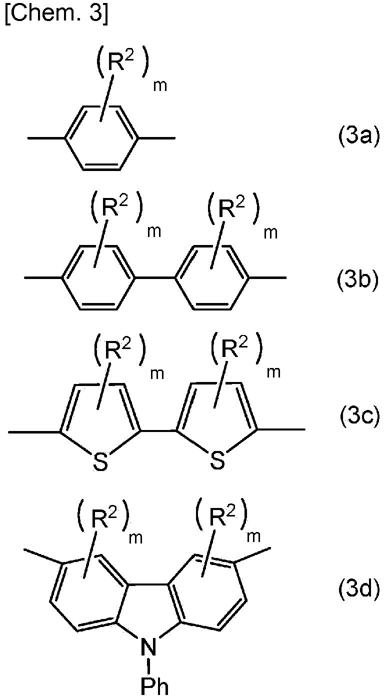 (in den Formeln, R² steht für eine monovalente organische Gruppe, m steht für einen Integer von 0 bis zu der Anzahl an Stellen, welche eine Substitution an dem Ring zulassen, an dem R² gebunden ist; und Ph steht für eine Phenyl-Gruppe; mit der Maßgabe, dass falls m größer als oder gleich 2 ist, die mehrfach auftretenden Gruppen R² gleich oder unterschiedlich sind).

9. Das Herstellverfahren nach Anspruch 8, wobei ein einzelnes Selten-Erd-Ion eine Koordinationsstruktur mit einer Koordinationszahl von größer als oder gleich 8 ausbildet, in welcher eine Mehrzahl der polydentaten Phosphanoxid Liganden jeweils an einer einzigen Stelle an das Selten-Erd-Ion koordinieren, und eine Mehrzahl der Liganden nach der Formel (1) jeweils über zwei Stellen an das Selten-Erd-Ion koordinieren.

## Revendications

1. Procédé pour fabriquer un film mince d'un polymère complexe des terres rares comprenant les étapes de :
(1) mélange d'une solution A contenant des micelles contenant un complexe des terres rares et un tensioactif ferrocénylique et une solution B contenant des micelles contenant des ligands polydentés et un tensioactif ferrocénylique pour former une solution contenant un mélange de micelles ;
(2) électrolyse de la solution contenant un mélange de micelles en tant qu'électrolyte, formant un film mince d'un polymère complexe des terres rares contenant le complexe des terres rares et les ligands polydentés sur une surface d'anode ; dans lequel :
- le complexe des terres rares comprend un ion des terres rares et un ligand désigné par la formule (1) ci-dessous coordonné avec l'ion des terres rares : 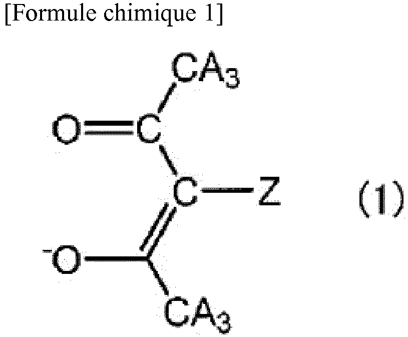 (dans la formule, A désigne un atome d'hydrogène ou un atome d'halogène et Z désigne un atome d'hydrogène ou un atome de deutérium) ;
- le ligand polydenté est un composé ayant deux ou plus groupes fonctionnels coordinateurs d'au moins un type pour un ion des terres rares ; et
- le polymère composé des terres rares comprend une structure réticulée du ligand polydenté et du complexe des terres rares.

2. Procédé de fabrication selon la revendication 1, dans lequel le mélange est laissé reposer pendant 0 à 48 heures après mélange des solutions A et B contenant des micelles lors de la formation de la solution contenant un mélange de micelles dans l'étape (1), et est ensuite soumis à une électrolyse dans l'étape (2).

3. Procédé de fabrication selon la revendication 1 ou 2, dans lequel des solutions A et B contenant des micelles sont formées de sorte que le diamètre moyen des micelles est inférieur ou égal à 500 nm.

4. Procédé de fabrication selon l'une quelconque des revendications 1 à 3, dans lequel le diamètre moyen des micelles mélangées soumises à de l'électrolyse dans l'étape (2) est plus grand que le diamètre moyen des solutions A et B contenant des micelles avant mélange.

5. Procédé de fabrication selon l'une quelconque des revendications 1 à 4, dans lequel le tensioactif ferrocénylique est du polyéthylène glycol ferrocénylique.

6. Procédé de fabrication selon l'une quelconque des revendications 1 à 5, dans lequel le ligand polyvalent est un composé comprenant deux ou plus d'au moins un groupe fonctionnel coordinateur sélectionné à partir du groupe consiste en des groupes oxyde de phosphine, des groupes pyridyle, des groupes acide carboxylique et des groupes ester.

7. Procédé de fabrication selon l'une quelconque des revendications 1 à 5, dans lequel le ligand polyvalent est le ligand bivalent d'oxyde de phosphine désigné par la formule (2) ci-dessous : 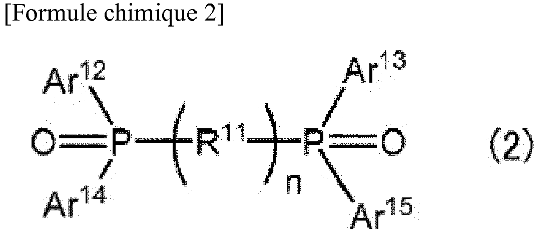 (dans la formule, R¹¹ désigne un groupe organique divalent ; chacun de Ar¹², Ar¹³, Ar¹⁴ et Ar¹⁵ désigne indépendamment un groupe aromatique monovalent substitué de manière optionnelle, étant possible que Ar¹² et Ar¹³, et Ar¹⁴ et Ar¹⁵ soient directement liés ensemble ou liés par l'intermédiaire de groupes connecteurs ; et n désigne un entier de 1 à 20).

8. Procédé de fabrication selon la revendication 7, dans lequel R¹¹ est le groupe désigné par la formule (3a) ci-dessous, le groupe désigné par la formule (3b) ci-dessous, le groupe désigné par la formule (3c) ci-dessous, ou le groupe désigné par la formule (3d) ci-dessous : 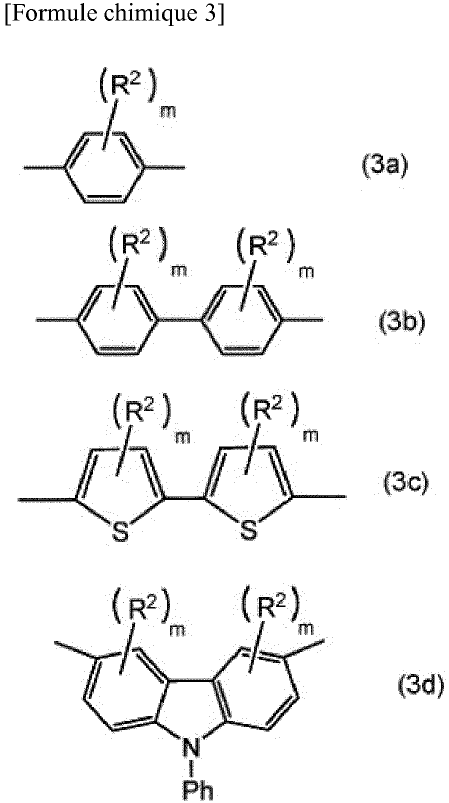 (dans les formules, R² désigne un groupe organique monovalent, m désigne un entier de 0 au nombre de sites permettant la substitution sur l'anneau auquel R² est lié ; et Ph désigne un groupe phényle ; de sorte que lorsque m est supérieur ou égal à 2, les occurrences multiples de R² sont identiques ou différentes).

9. Procédé de fabrication selon la revendication 8, dans lequel un unique ion des terres rares forme une structure de coordination avec un nombre de coordination supérieur ou égal à 8, dans lequel une pluralité des ligands polydentés d'oxyde de phosphine sont coordonnés au niveau d'un site unique chacun avec l'ion des terres rares, et une pluralité des ligands désignés par la formule (1) sont coordonnés au niveau de deux sites chacun avec l'ion des terres rares.
